(19) Europäisches Patentamt
European Patent Office
Office européen des brevets

(11) **EP 2 088 522 B1**

(12) **EUROPÄISCHE PATENTSCHRIFT**

(45) Veröffentlichungstag und Bekanntmachung des Hinweises auf die Patenterteilung:
**24.12.2014  Patentblatt 2014/52**

(51) Int Cl.:
***G06F 17/50*** *(2006.01)*

(21) Anmeldenummer: **08017424.6**

(22) Anmeldetag: **02.10.2008**

(54) **Verfahren und Vorrichtung zur Emulation von Hardwarebeschreibungsmodellen zur Herstellung von Prototypen für integrierte Schaltungen**

Device and method for emulating hardware description models for producing prototypes for integrated switches

Procédé et dispositif d'émulation de modèles de description de matériel pour la fabrication de prototypes pour circuits intégrés

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **15.01.2008   DE 102008004451**

(43) Veröffentlichungstag der Anmeldung:
**12.08.2009   Patentblatt 2009/33**

(73) Patentinhaber: **Synopsys, Inc.**
**Mountain View, CA 94043 (US)**

(72) Erfinder: **Mauersberger, Heiko**
**99330 Crawinkel (DE)**

(74) Vertreter: **Schlimme, Wolfram**
**Haidgraben 2**
**85521 Ottobrunn (DE)**

(56) Entgegenhaltungen:
**US-A- 5 850 537     US-B1- 7 007 254**
**US-B1- 7 086 025**

- **BABB J ET AL: "Virtual wires: overcoming pin limitations in FPGA-based logic emulators" FPGAS FOR CUSTOM COMPUTING MACHINES, 1993. PROCEEDINGS. IEEE WORKSHOP ON NAPA, CA, USA 5-7 APRIL 1993, LOS ALAMITOS, CA, USA,IEEE COMPUT. SOC, US, 5. April 1993 (1993-04-05), Seiten 142-151, XP010096016 ISBN: 978-0-8186-3890-9**
- **JONATHAN BABB ET AL: "Logic Emulation with Virtual Wires" IEEE TRANSACTIONS ON COMPUTER AIDED DESIGN OF INTEGRATEDCIRCUITS AND SYSTEMS, IEEE SERVICE CENTER, PISCATAWAY, NJ, US, Bd. 16, Nr. 6, 1. Juni 1997 (1997-06-01), XP011007437 ISSN: 0278-0070**

**Beschreibung**

Die Erfindung betrifft ein Verfahren zur Emulation von Hardwarebeschreibungsmodellen zur Herstellung von Prototypen für integrierte Schaltungen mit den Schritten gemäß dem Oberbegriff des Patentanspruchs 1. Die Erfindung betrifft weiterhin eine Vorrichtung zur Durchführung eines derartigen Verfahrens.

Verfahren zur Emulation von Hardwarebeschreibungsmodellen zur Herstellung von Prototypen für integrierte Schaltungen sind allgemein bekannt. Dabei werden häufig frei programmierbare Halbleiterbausteine, zum Beispiel FPGAs, eingesetzt, die miteinander elektrisch verbunden sind. Aufgrund der Vielzahl von Eingangs-/Ausgangs-Anschlüssen eines jeden FPGA - es können pro FPGA bis zu 1.200 Anschlüsse vorgesehen sein - ist es nicht möglich, für jeden der Anschlüsse eines jeden FPGA eine physikalische Verbindungsleitung innerhalb der Verbindungsstruktur zu einem mit diesem verbundenen anderen frei programmierbaren Halbleiterbaustein vorzusehen.

Aus diesem Grund wird jeweils eine Gruppe von Anschlüssen eines jeden FPGA einem Serialisierer/Deserialisierer zugeordnet, von welchem aus dann eine physikalische Verbindungsleitung für den Datentransport zu einem Serialisierer/Deserialisierer eines weiteren frei programmierbaren Halbleiterbausteins führt.

Ein Beispiel für eine derartige Struktur ist in der US 7,007,254 B1 angegeben. Dort wird zur Serialisierung und Deserialisierung das Verfahren des zeitbasierten Multiplexens (TDM = time division muliplexing) eingesetzt. Die von einem ersten frei programmierbaren Halbleiterbaustein, beispielsweise einem ersten FPGA, über eine erste Gruppe von Anschlusskontakten ausgegebenen Signale werden mittels eines ersten TDM-Multiplexers zeitbasiert gemultiplext und über eine physikalische Verbindung zu einem als Deserialisierer arbeitenden Multiplexer eines zweiten frei programmierbaren Halbleiterbausteins, beispielsweise eines zweiten FPGA, übertragen. Im zweiten Multiplexer werden die über die physikalische Verbindung ankommenden Signale dann deserialisiert und den entsprechenden Eingangsanschlüssen des zweiten frei programmierbaren Halbleiterbausteins zugeführt.

Ein beiden Multiplexern gemeinsames Taktsignal, auch Clock-Signal genannt, liefert eine Zeittaktung für das Verfahren der Serialisierung beziehungsweise Deserialisierung. Um die Funktionsfähigkeit des die beiden frei programmierbaren Halbleiterbausteine aufweisenden Emulationssystems zu gewährleisten, muss die Taktung dieses Clock-Signals eine deutlich höhere Frequenz aufweisen, als die für den Betrieb der frei programmierbaren Halbleiterbausteine, also für die Emulation, gewählte Frequenz beziehungsweise Taktung.

Durch die beiden Multiplexing-Schritte, also die Serialisierung und Deserialisierung der Daten auf dem Weg vom ersten frei programmierbaren Halbleiterbaustein zum zweiten frei programmierbaren Halbleiterbaustein, wird die Datenübertragung zwischen den beiden frei programmierbaren Halbleiterbausteinen gegenüber einer theoretischen Anordnung, bei der jeder Ausgangsanschluss des ersten frei programmierbaren Halbleiterbausteins mit jedem Eingangsanschluss des zweiten frei programmierbaren Halbleiterbausteins physikalisch verbunden ist, verzögert. Diese Verzögerung wiederum tritt in der zu emulierenden Schaltung nicht auf, da dort die entsprechenden Schaltungsbausteine in der Tat physikalisch miteinander verbunden sind.

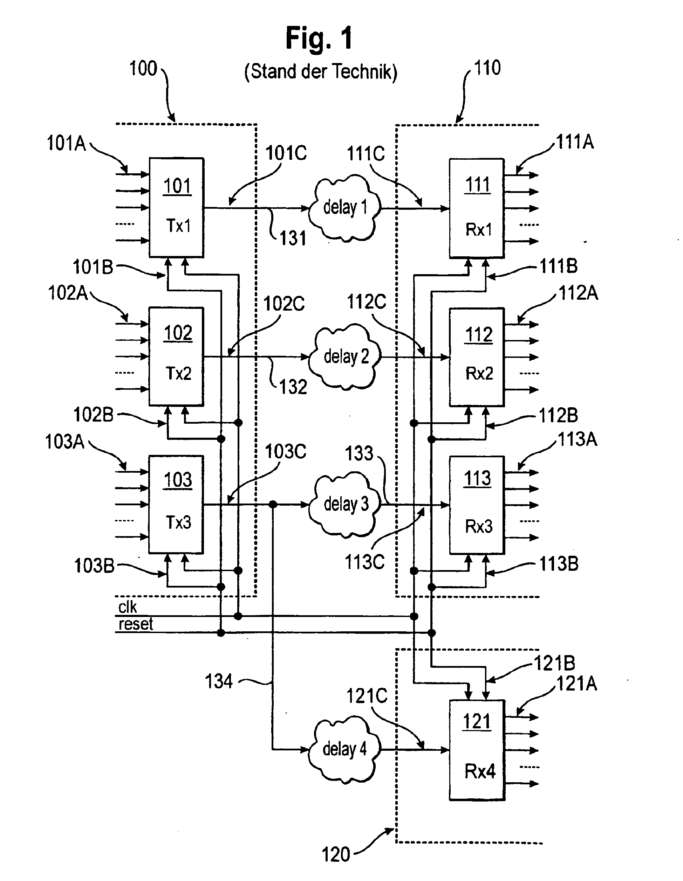

In Fig. 1 ist eine andere bekannte Verbindungsstruktur zwischen drei frei programmierbaren Halbleiterbausteinen (FPGAs) in einer Vorrichtung zur Emulation von Hardwarebeschreibungsmodellen zur Herstellung von Prototypen für integrierte Schaltungen dargestellt. Der erste FPGA 100 weist eine Mehrzahl von Zeitmultiplex-Komponenten auf, von denen in Fig. 1 drei Zeitmultiplex-Komponenten 101, 102, 103 gezeigt sind. Jede der drei Zeitmultiplex-Komponenten 101, 102, 103 besitzt eine Vielzahl von elektrischen Signaleingängen, die in Fig. 1 als Pfeile dargestellt sind, die auf die entsprechende Zeitmultiplex-Komponente gerichtet sind. Eine erste Gruppe von Signaleingängen 101A, 102A 103A liefert Signale der zu emulierenden Schaltungsstruktur im jeweiligen FPGA an die Zeitmultiplex-Komponente 101, 102, 103. Über eine jeweilige weitere Gruppe von Eingängen 101B, 102B, 103B werden Taktsignale, die auch als Clock-Signale "clk" bezeichnet werden, und Rücksetzsignale "reset" der jeweiligen Zeitmultiplex-Komponente 101, 102, 103 zugeführt.

Jede der Zeitmultiplex-Komponenten 101, 102, 103 weist zumindest einen Signalausgang 101C, 102C, 103C für das gemultiplexte Signal auf. Der jeweilige Signalausgang 101C, 102C, 103C ist mit einer physikalischen Verbindung 131, 132, 133 zu einem Signaleingang 111C, 112C, 113C einer zugeordneten, als Demultiplexer dienenden Zeitmultiplex-Komponente 111, 112, 113 eines zweiten FPGA 110 elektrisch leitend verbunden.

Jede der als Demultiplexer dienenden Zeitmultiplex-Komponenten 111, 112, 113 des zweiten FPGA 110 ist mit einer Vielzahl von Signalausgängen 111A, 112A, 113A versehen, die zu einer im zweiten FPGA 110 abgebildeten Schaltungsstruktur führen. Über eine zweite Gruppe von Signaleingängen 111B, 112B, 113B werden der jeweiligen Zeitmultiplex-Komponente 111, 112, 113 des zweiten FPGA 110 die Clock-Signale "clk" und die Rücksetzsignale "reset" zugeführt.

Ein dritter FPGA 120 ist in Fig. 1 beispielhaft mit einer Signale empfangenden, als Demultiplexer arbeitenden Zeitmultiplex-Komponente 121 versehen. Diese Zeitmultiplex-Komponente 121 besitzt einen Signaleingang 121C, der über eine physikalische Verbindung 134 mit der physikalischen Verbindung 133 zwischen der dritten Zeitmultiplex-Komponente 103 des ersten FPGA 100 und der dritten Zeitmultiplex-Komponente 113 des zweiten FPGA 110 in Verbindung steht. Die Zeitmultiplex-Komponente 121 des dritten FPGA 120 enthält eine Vielzahl von Signalausgängen 121A, die zu einer im dritten FPGA 120 abgebildeten Schaltungsstruktur führen. Weiterhin ist die Zeitmultiplex-Komponente 121 mit Signaleingängen 121B für die Clock-Signale "clk" und die Rücksetzsignale "reset" versehen.

Auf der Verbindung 131, 132, 133, 134 zwischen jeder der sendenden Zeitmultiplex-Komponenten 101, 102, 103 und der/den zugeordneten Komponente(n) 111, 112, 113, 121 werden die übertragenen Signale der jeweils im FPGA 100, 110, 120 abgebildeten (nicht gezeigten) Schaltungsstrukturen Verzögerungen "delay 1", "delay 2", "delay 3", "delay 4" unterworfen. Zu Beginn der Datenübertragung erfolgt eine Synchronisierung aller beteiligten Zeitmultiplex-Komponenten durch ein diesen Zeitmultiplex-Komponenten zugeführtes Rücksetzsignal "reset". Um die Funktion der Zeitmultiplex-Komponenten zu gewährleisten, wird diesen Komponenten ein Taktsignal, auch als Clock-Signal "clk" bezeichnet, zugeführt.

Das Interesse in der Fachwelt besteht jedoch darin, die Taktfrequenzen von elektronischen Schaltungen zu erhöhen.

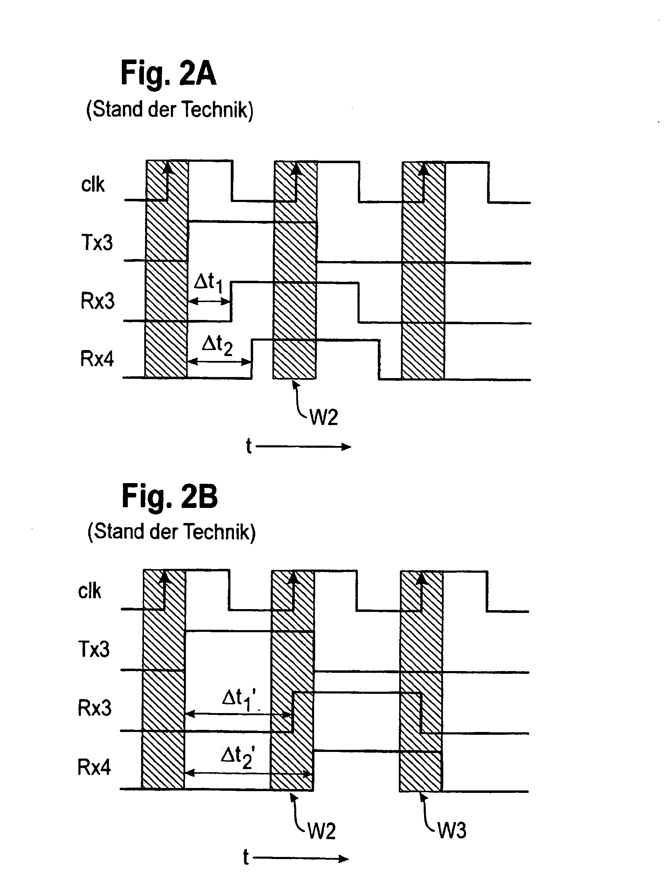

Fig. 2A zeigt für die physikalischen Verbindungen 133 und 134 zwischen der Zeitmultiplex-Komponente 103 des ersten FPGA 100 und den Zeitmultiplex-Komponenten 113 des zweiten FPGA 110 und 121 des dritten FPGA 120 ein Diagramm des Zeitablaufs der einzelnen Signale. Von dem als Rechtecksignal ausgebildeten Clock-Signal "clk" sind zwei Phasen vollständig dargestellt. Jeweils im Bereich des Flankenanstiegs des Clock-Signals, der durch einen vertikal nach oben gerichteten Pfeil dargestellt ist, wird ein Meßfenster (in den Figuren grau hinterlegt) definiert. Der Flankenanstieg des Clock-Signals triggert die sendende Zeitmultiplex-Komponente 103, die das Signal Tx3 aussendet. Es ist aus Fig. 2A erkennbar, dass die Phasenlänge des Clock-Signals wesentlich kürzer und damit dessen Frequenz wesentlich höher ist als jene des von der Zeitmultiplex-Komponente 103 ausgesendeten Signals Tx3.

Des Weiteren ist in Fig. 2A das an der als Demultiplexer arbeitenden dritten Zeitmultiplex-Komponente 113 des zweiten FPGA 110 über die physikalische Leitung 133 ankommende Signal Rx3 gezeigt. Es ist aus Fig. 2A erkennbar, dass das Signal Rx3 gegenüber dem ursprünglich ausgesendeten Signal Tx3 mit einer zeitlichen Verzögerung $\Delta t_1$ ankommt.

Weiterhin ist in Fig. 2A das über den physikalischen Verbindungsweg 134 bei der als Demultiplexer arbeitenden Zeitmultiplex-Komponente 121 des dritten FPGA 120 ankommende Signal Rx4 dargestellt. Das Signal Rx4 kommt gegenüber dem ausgesendeten Signal Tx3 mit einer zeitlichen Verzögerung $\Delta t_2$ an, die größer ist, als die zeitliche Verzögerung $\Delta t_1$ des Signals Rx3. Aus Fig. 2A ist erkennbar, dass das zweite Messfenster W2 so gelegen ist, dass in ihm alle drei Signale, nämlich das ausgesendete Signal Tx3 und die beiden empfangenen Signale Rx3 und Rx4, ihren High-Status haben. Das ausgesendete Signal Tx3 kann also sowohl an der Zeitmultiplex-Komponente 113, als auch an der Zeitmultiplexkomponente 121 problemlos empfangen werden.

Fig. 2B zeigt eine Darstellung, bei der die zeitlichen Verzögerungen $\Delta t_1{}'$ und $\Delta t_2{}'$ größer sind, als die Verzögerungen $\Delta t_1$ und $\Delta t_2$ bei der Darstellung in Fig. 2A. Diese graphische Darstellung entspricht vom Prinzip her einer Situation, in welcher gegenüber der Fig. 2A die zeitlichen Verzögerungen $\Delta t_1{}'$ und $\Delta t_2{}'$ gleich bleiben, aber die Clock-Frequenz erhöht wird, also die Phasenlänge des Clock-Signals verkürzt wird. Es ist in Fig. 2B zu erkennen, dass aufgrund der Erhöhung der Clock-Frequenz beziehungsweise der Vergrößerung der Verzögerung auf den physikalischen Leitungen 133 und 134 das zweite Messfenster W2 möglicherweise noch den Flankenanstieg des Signal Rx3 empfängt, nicht aber mehr den Flankenanstieg des Signals Rx4; dieser wird erst im zeitlich darauffolgenden dritten Messfenster W3 erfasst.

Die maximal mögliche Clock-Frequenz für das Multiplexen/Demultiplexen aller in Fig. 1 dargestellten physikalischen Verbindungen 131, 132, 133, 134 bestimmt sich nach der Formel:

$$f_{\max} = \frac{1}{\max(delay_i)} \qquad \forall i$$

Wenn die Regel dieser Formel nicht eingehalten wird, ist die Signalübertragung zwischen den einzelnen FPGAs 100, 110, 120 gestört.

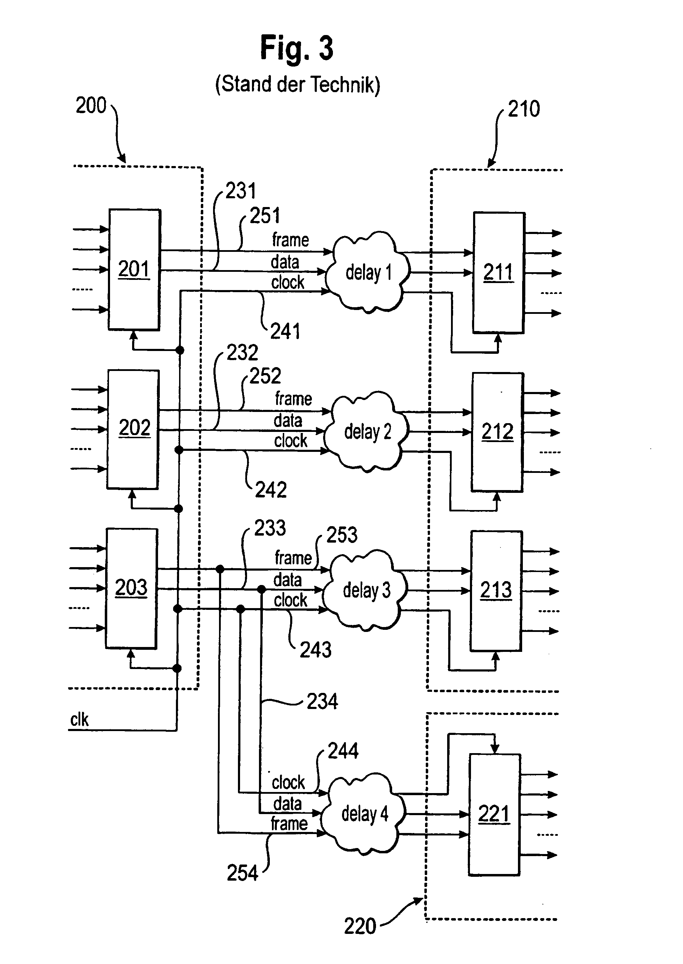

Fig. 3 zeigt schematisch eine Verbindungsstruktur in einer Vorrichtung zur Emulation von Hardwarebeschreibungsmodellen, wie sie aus der US 7,086,025 A bekannt ist. Die Bezugszeichen, die die gleichen Elemente betreffen wie bei der Darstellung in Fig. 1, sind mit einem gegenüber der Darstellung in Fig. 1 um den Wert 100 erhöhten Bezugszeichen versehen. Nachstehend werden lediglich die Unterschiede dieser Ausführungsform gegenüber der in Fig. 1 dargestellten Verbindungsstruktur beschrieben.

In der in Fig. 3 gezeigten Verbindungsstruktur wird das Taktsignal "clk" nicht unmittelbar zur Empfängerseite, also zum zweiten FPGA 210 und zum dritten FPGA 220 geführt, sondern es wird von der Senderseite, also vom ersten FPGA 200, über eine physikalische Verbindung 241, 242, 243, 244 zum jeweiligen empfängerseitigen Demultiplexer 211, 212, 213, 221 geführt, die dieselbe zeitliche Verzögerung aufweist, wie die jeweilige physikalische Verbindung zur Datenübertragung 231, 232, 233, 234. Des Weiteren wird vom jeweiligen Multiplexer 201, 202, 203 des ersten FPGA 200 über eine physikalische Verbindung 251, 252, 253, 254 ein Frame-Signal zum jeweils zugeordneten Demultiplexer 211, 212, 213 und 221 des zweiten FPGA 210 beziehungsweise des dritten FPGA 220 auf der Empfängerseite geführt. Auch diese physikalische Verbindung 151, 152, 153, 154 für das Frame-Signal weist dieselben zeitlichen Verzögerungen auf wie die physikalische Verbindung 231, 232, 233, 234 für das Datensignal.

Mit dieser aus dem Stand der Technik bekannten Verbindungsstruktur wird zwar der Nachteil der in Fig. 1 dargestellten Verbindungsstruktur überwunden, da hier das jeweilige Datensignal und das jeweilige Clock-Signal derselben zeitlichen Verzögerung unterworfen sind. Das Frame-Signal wird benötigt, um zu erkennen, ob auf der Empfängerseite gültige Signalwerte empfangen werden.

Das Problem der in Fig. 3 dargestellten Verbindungsstruktur besteht jedoch darin, das zusätzliche physikalische Verbindungen, nämlich für das Clock-Signal und für das Frame-Signal, benötigt werden. Dadurch werden gegenüber der in Fig. 1 gezeigten Darstellung wesentlich mehr Anschlußkontakte des FPGA belegt, die dann nicht für die eigentliche Datenübertragung zur Verfügung stehen. Hinzu kommt, dass auch eine Vielzahl zusätzlicher physikalischer Verbindungen zwischen den einzelnen FPGAs benötigt wird, was wiederum einer Reduzierung der Baugröße entgegensteht. Ein weiterer Nachteil besteht darin, dass für jeden Routingweg, also für jeden Weg zwischen einem sendenden Multiplexer und einem empfangenden Demultiplexer unterschiedliche Verzögerungen auftreten, so dass die Anzahl der beim empfangenden FPGA ankommenden Taktsignale die hierfür vorgesehenen Kapazitäten eines FPGA schnell überschreiten kann.

Solange wie die Verzögerung der Signallaufzeit geringer ist, als die Taktfrequenz des Clock-Signals für die Serialisierung/Deserialisierung werden die Signale auf der Sekundärseite, also im Deserialisierer, problemlos identifiziert und deserialisiert. Es ist jedoch ein ständiges Bestreben, die Zeit für die Emulation eines Hardwarebeschreibungsmodells zu reduzieren, woraus sich die Anforderung ergibt, auch die zeitliche Taktung bei der Serialisierung/Deserialisierung der zwischen zwei frei programmierbaren Halbleiterbausteinen übertragenen Signale zu verkürzen, das heißt, die Takt-Frequenz des Clock-Signals zu erhöhen. Eine derartige Erhöhung der Taktfrequenz des Clock-Signals kann jedoch dann, wenn die Taktlänge des Clock-Signals kürzer wird, als die Verzögerung der Signalübertragung zwischen dem Serialisierer und dem Deserialisierer, dazu führen, dass Signale verspätet oder gar nicht erkannt werden. Der Erhöhung der Taktfrequenz und damit der Beschleunigung des Emulationsprozesses sind daher Grenzen gesetzt.

Das Dokument US-A-5850537 zeigt ein Verfahren zur Emulation von Hardwarebeschreibungsmodellen mit allen Merkmalen des oberbegriffs des Anspruchs 1 und eine vorrichtung mit allen Merkmalen des Oberbegriffs des Anspruchs 10.

Aufgabe der vorliegenden Erfindung ist es, ein gattungsgemäßes Verfahren sowie eine gattungsgemäße Vorrichtung anzugeben, die gegenüber dem Stand der Technik eine spürbare Beschleunigung des gesamten Emulationsprozesses gestatten.

Die das Verfahren betreffende Aufgabe wird gelöst durch das im Patentanspruch 1 angegebene Verfahren. Erfindungsgemäß werden im Verfahrensablauf bis zur Durchführung der Emulation des Chipdesigns zusätzlich Signal-Laufzeitverzögerungen zwischen den einzelnen Halbleiterbausteinen bestimmt und die Taktfrequenz des Clock-Signals für die Serialisierung/Deserialisierung wird optimiert. Weiterhin werden die so ermittelten Signal-Laufzeitverzögerungen bei der Emulation berücksichtigt.

Vorzugsweise erfolgen die Bestimmung der Signal-Laufzeitverzögerungen zwischen den einzelnen Halbleiterbausteinen und die Optimierung der Taktfrequenz des Clock-Signals nach dem Übertragen (Platzieren und Trassieren) der in Teilnetzlisten partitionierten Gatternetzliste auf eine zumindest zwei frei programmierbare Halbleiterbausteine aufweisende Emulationsplattform und vor dem Übertragen (Platzieren und Trassieren) einer jeden Teilnetzliste auf jeweils einen der frei programmierbaren Halbleiterbausteine.

Alternativ können die Bestimmung der Signal-Laufzeitverzögerungen zwischen den einzelnen Halbleiterbausteinen und die Optimierung der Taktfrequenz des Clock-Signals auch nach dem Konfigurieren der die frei programmierbaren Halbleiterbausteine aufweisenden Emulationsplattform mit dem zu emulierenden Chipdesign und vor der Durchführung der Emulation des Chipdesigns erfolgen.

In einer bevorzugten Ausführungsform werden zur Bestimmung der Signal-Laufzeitverzögerungen und zur Optimierung der Taktfrequenz des Clock-Singals zwischen dem ersten, Signale aussendenden Halbleiterbaustein und dem zweiten, Signale empfangenden Halbleiterbaustein die folgenden Schritte durchgeführt:

h1) Auswählen einer ersten physikalischen Verbindung zwischen einem ersten Anschluss des ersten Halbleiterbausteins über einen auf der Plattform vorgesehenen Verbindungsweg zu einem ersten Anschluss des zweiten Halbleiterbausteins;

h2) Vorgeben einer Start-Taktfrequenz und einer Start-Phasenverschiebung von $\varphi=0°$ für das empfängerseitige Clock-Signal;

h3) Synchronisieren des empfangenden Halbleiterbausteins mit dem sendenden Halbleiterbaustein und Gleichsetzen des senderseitigen getakteten Clock-Signals mit dem empfängerseitigen getakteten Clock-Signal;

h4) Aussenden eines auf der Basis des senderseitigen getakteten Clock-Signals serialisierten Testsignals vom ersten Halbleiterbaustein über den Verbindungsweg zum zweiten Halbleiterbaustein;

h5) Empfangen des auf der Basis des empfängerseitigen getakteten Clock-Signals deserialisierten Testsignals am zweiten Halbleiterbaustein und Prüfen, ob das Testsignal korrekt empfangen wird;

h6) Speichern des Phasenverschiebungswerts ($\varphi$) für das empfängerseitige Clock-Signal, wenn das Testsignal im Schritt h5) erkannt worden ist;

h7) Erhöhen der Phasenverschiebung ($\varphi$) des empfängerseitigen Clock-Signals um einen vorgegebenen Betrag;

h8) Wiederholen der Schritte h3) bis h5) so lange bis die Phasenverschiebung ($\varphi$) des empfängerseitigen Clock-Signals größer ist, als der Kehrwert der Taktfrequenz (f) des senderseitigen Clock-Signals;

h9) Berechnen des durchschnittlichen Phasenverschiebungswerts ($\varphi_n$) aus den im Schritt h6) gespeicherten Phasenverschiebungswerten;

h10) Speichern der Daten für

- die aktuelle Taktfrequenz ($f_n$)
- den durchschnittlichen Phasenverschiebungswert ($\varphi_n$)
  als aktueller Datensatz; und

h11) Erhöhen der Taktfrequenz (f) um einen vorgegebenen Betrag und Rücksetzen der Phasenverschiebung ($\varphi$) auf den Anfangswert $\varphi=0°$, wenn das Testsignal im Schritt h5) noch erkannt worden ist, und Wiederholen der Schritte h3) bis h10); oder

h11') Wiederholen der Schritte h1) bis h11) für die weiteren physikalischen Verbindungen zwischen dem ersten Halbleiterbaustein und dem zweiten Halbleiterbaustein, wenn das Testsignal im Schritt h5) nicht mehr erkannt worden ist.

Besonders vorteilhaft ist es dabei, wenn zwischen den Schritten h8) und h9) noch der folgende Schritt durchgeführt wird:

h8') Ermitteln der Signalverzögerung ($\delta_n$) auf der gewählten physikalischen Verbindung in Taktzyklen des senderseitigen Clock-Signals;

und dass die so ermittelte Signalverzögerung ($\varphi_n$) im Schritt h10) im aktuellen Datensatz ebenfalls gespeichert wird.

Die im Schritt h9) erfolgende Berechnung des durchschnittlichen Phasenverschiebungswerts ist die Berechnung des arithmetischen Mittels. Theoretisch müsste ein auf der Senderseite ausgesandtes Signal auf der Empfängerseite über den gesamten Phasenbereich korrekt empfangen werden können, sofern die Flankensteilheit der Signale ideal wäre und keine Störungen auftreten würden. In der Praxis jedoch besitzen die Flanken Anstiegs- und Abfallzeiten. Außerdem treten Störungen wie Reflexionen oder Übersprechen auf. Eine Minimierung derartiger Störungen wird jedoch schwieriger, je höher die Frequenz wird. Daraus folgt, dass ein korrekter Signalempfang nicht mehr im gesamten Phasenbereich möglich ist.

Der Erfinder hat nun erkannt, dass es ein optimales Empfangsfenster gibt, in welchem die Signale korrekt empfangen werden. Durch die Weiterbildung des erfindungsgemäßen Verfahrens entsprechend der Merkmale h1) bis h11') wird dieses optimale Empfangsfenster ermittelt. In den Randgebieten dieses Fensters treten jedoch insofern noch Unschärfen, wie Flankenverschiebungen, auf, die zum Beispiel durch Temperaturveränderungen verursacht werden.

Die Berechnung des durchschnittlichen Phasenverschiebungswerts im Schritt h9) ist an sich eine vorteilhafte Weiterbildung des in den Schritten h1) bis h8) und h10) bis h11') angegebenen Verfahrens, die durch die Bildung des Mittelwerts den größten Abstand des idealen Empfangszeitpunktes zu den Randgebieten des Empfangsfensters gewährleistet und somit für eine größtmögliche Übertragungssicherheit sorgt.

Bei Vorhandensein von mehr als zwei frei programmierbaren Halbleiterbausteinen auf der Plattform werden bevorzugterweise die Schritte h1) bis h11') für alle physikalischen Verbindungen zwischen den einzelnen Halbleiterbausteinen durchgeführt.

Besonders vorteilhaft ist es, wenn zur Berücksichtigung der Signal-Laufzeitverzögerungen bei der Emulation die folgenden Schritte durchgeführt werden:

g1) Ermitteln der allen physikalischen Verbindungen gemeinsamen, in den Schritten h1) bis h11') ermittelten höchsten Taktfrequenz ($f_{max}$);

g2) Ermitteln des größten Phasenverschiebungsbetrags ($\varphi_{max}$) der in den Schritten h1 bis h11') ermittelten Phasenverschiebungsbeträge aller physikalischen Verbindungen;

g3) Berechnen eines jeweiligen Verzögerungswerts ($\Delta\varphi_n$) für jede der auf der Plattform vorgesehenen physikalischen Verbindungen als Differenz zwischen dem größten Phasenverschiebungsbetrag ($\varphi_{max}$) und dem in den Schritten h1) bis h11') ermittelten Phasenverschiebungsbetrag ($\varphi_n$) der jeweiligen physikalischen Verbindung ($V_n$);

g4) Zuweisen des jeweiligen Verzögerungswerts ($\Delta\varphi_n$) zu einer Eingangs- und/oder Ausgangs-Verzögerungsstufe der zugeordneten physikalischen Verbindung ($V_n$);

g5) Zuweisen des größten Phasenverschiebungsbetrags ($\varphi_{max}$) zu einer Phasenverschiebungsstufe für das Clock-Signal;

g6) Zuweisen der im Schritt g1) ermittelten höchsten Taktfrequenz ($f_{max}$) zum Clock-Signal-Erzeuger und Erzeugen des Clock-Signals mit der zugewiesenen höchsten Taktfrequenz ($f_{max}$).

Vorzugsweise erfolgt der Schritt des Synchronisierens des empfangenden Halbleiterbausteins mit dem sendenden Halbleiterbaustein im Schritt h2) durch Verwendung eines globalen Rücksetzsignals und eines Synchronisationszählers auf der Seite des empfangenden Halbleiterbausteins.

Es kann aber auch vorteilhaft sein, wenn der Schritt des Synchronisierens des empfangenden Halbleiterbausteins mit dem sendenden Halbleiterbaustein im Schritt h2) durch Verwendung eines Synchronisations-Signalmusters erfolgt, das vom sendenden Halbleiterbaustein ausgesandt und vom empfangenden Halbleiterbaustein verarbeitet wird.

Vorzugsweise erfolgt die Serialisierung (und folglich auch die Deserialisierung) durch zeitbasiertes Multiplexen.

Alternativ kann die Serialisierung (und folglich auch die Deserialisierung) auch durch Verwendung eines zeitbasierten Schieberegisters erfolgen.

Vorzugsweise ist die Phasenlänge des Clock-Signals kleiner als die Signalverzögerungen der physikalischen Verbindung, insbesondere der Verbindung zwischen dem Serialisierer und dem Deserialisierer.

Die Erfindung ist außerdem gerichtet auf ein Verfahren zur Prognose einer maximalen Arbeitsfrequenz eines Chipdesigns mit den Schritten:

x) Durchführen einer Timing-Analyse eines gemäß dem Verfahren nach einem der vorhergehenden Ansprüche emulierten Chipdesigns, um eine optimierte Basis-Arbeitsfrequenz zu erhalten, und

y) Korrigieren der im Schritt x) erhaltenen Basis-Arbeitsfrequenz um die bei der optimierten Taktfrequenz im Schritt h) erhaltenen Laufzeitverzögerungen.

Mittels dieses Verfahrens kann bereits bei der Emulation eines Chipdesigns eine Prognose über die mit diesem Chipdesign maximal erreichbare Arbeitsfrequenz getroffen werden.

Der die Vorrichtung zur Durchführung des erfindungsgemäßen Verfahrens betreffende Teil wird gelöst durch die Vorrichtung mit den Merkmalen des Anspruchs 14. Eine derartige erfindungsgemäße Vorrichtung ist ausgestattet mit einer Emulationsplattform, die einen ersten frei programmierbaren Halbleiterbaustein und zumindest einen weiteren frei programmierbaren Halbleiterbaustein aufweist, wobei die frei programmierbaren Halbleiterbausteine jeweils mit einer Vielzahl von elektrischen Anschlüssen versehen sind; einer Vielzahl von physikalischen Verbindungen, die Anschlüsse des ersten frei programmierbaren Halbleiterbausteins mit jeweils einem zugeordneten Anschluss des weiteren frei programmierbaren Halbleiterbausteins elektrisch verbinden; wobei jedem frei programmierbaren Halbleiterbaustein zumindest eine Ausgangs-Verzögerungsstufe zum Verzögern von auszusendenden Signalen und/oder zumindest eine Eingangs-Verzögerungsstufe zum Verzögern von zu empfangenden Signalen derart zugeordnet ist, dass die Signale aussendenden Anschlüsse des frei programmierbaren Halbleiterbausteins mit der Ausgangs-Verzögerungsstufe wirksam verbunden sind und die Signale empfangenden Anschlüsse des frei programmierbaren Halbleiterbausteins mit der Eingangs-Verzögerungsstufe wirksam verbunden sind.

Jedem frei programmierbaren Halbleiterbaustein ist zumindest eine Signal-Ausgangsstufe zum Aussenden von Signalen und/oder zumindest eine Signal-Eingangsstufe zum Empfangen von Signalen derart zugeordnet ist, dass die Signale aussendenden Anschlüsse des frei programmierbaren Halbleiterbausteins mit der Signal-Ausgangsstufe verbunden sind und die Signale empfangenden Anschlüsse des frei programmierbaren Halbleiterbausteins mit der Signal-Eingangsstufe verbunden sind. Bei einer derartigen Vorrichtung weist bevorzugt eine jeweilige Signal-Ausgangsstufe einen Serialisierer auf und eine jeweilige Signal-Eingangsstufe weist einen Deserialisierer auf. Die Signal-Ausgangsstufe kann eine erste Synchronisationsstufe aufweisen und die Signal-Eingangsstufe kann eine zweite Synchronisationsstufe aufweisen.

Vorzugsweise ist einer jeweiligen Ausgangs-Verzögerungsstufe ein Serialisierer zugeordnet ist und einer jeweiligen Eingangs-Verzögerungsstufe ist ein Deserialisierer zugeordnet.

Eine bevorzugte Weiterbildung der erfindungsgemäßen Vorrichtung zeichnet sich dadurch aus, dass einer jeweiligen Ausgangs-Verzögerungsstufe eines jeden frei programmierbaren Halbleiterbausteins eine erste Synchronisationsstufe zugeordnet ist; dass einer jeweiligen Eingangs-Verzögerungsstufe eines jeden frei programmierbaren Halbleiterbausteins eine zweite Synchronisationsstufe zugeordnet ist; dass die ersten Synchronisationsstufen der frei programmierbaren Halbleiterbausteine der Emulationsplattform über eine erste Clock-Signal-Leitung mit einem ersten Taktsignal beaufschlagt sind; dass die zweiten Synchronisationsstufen der frei programmierbaren Halbleiterbausteine über zumindest eine weitere Clock-Signal-Leitung mit einem phasenverschobenen weiteren Taktsignal beaufschlagt sind; und dass die erste Clock-Signal-Leitung für das erste Taktsignal über eine Vorrichtung zur Phasenverschiebung mit der weiteren Clock-Signal-Leitung für das phasenverschobene weitere Taktsignal elektrisch verbunden ist.

In einer vorteilhaften Weiterbildung dieser Vorrichtung ist vorgesehen, dass mehrere Gruppen von weiteren frei programmierbaren Halbleiterbausteinen vorgesehen sind, wobei die frei programmierbaren Halbleiterbausteine einer jeden Gruppe mit einer eigenen, dieser Gruppe zugeordneten Clock-Signal-Leitung für ein phasenverschobenes Taktsignal elektrisch verbunden sind, die über eine dieser Gruppe zugeordnete Vorrichtung zur Phasenverschiebung mit der ersten Clock-Signal-Leitung elektrisch verbunden ist.

Bei einer weiteren bevorzugten Ausgestaltung der erfindungsgemäßen Vorrichtung sind die Eingangs-Verzögerungsstufen , die Ausgangs-Verzögerungsstufen, die Serialisierer, die Deserialisierer, die Synchronisationsstufen und/oder die Vorrichtungen zur Phasenverschiebung im jeweils zugeordneten frei programmierbaren Halbleiterbaustein gebildet. Hierdurch ist es nicht erforderlich, zusätzlich zu den frei programmierbaren Halbleiterbausteinen noch separate weitere Bausteine vorzusehen.

Eine besonders vorteilhafte und bevorzugte Ausgestaltungsform zeichnet sich dadurch aus, dass die frei programmierbaren Halbleiterbausteine durch FPGAs gebildet sind.

Eine Abwandlung der erfindungsgemäßen Vorrichtung sieht vor, dass der erste frei programmierbare Halbleiterbaustein von einem eine Schaltungslogik aufweisenden FPGA gebildet ist und dass der zweite frei programmierbare Halbleiterbaustein einen Logic-Analyzer aufweist.

Mittels dieser Vorrichtung lassen sich auf einfache Weise Logiktests der im FPGA vorgesehenen Schaltungslogik durchführen.

Die Erfindung wird nachfolgend anhand eines Beispiels unter Bezugnahme auf die Zeichnung näher erläutert. In dieser zeigt:

**Fig. 1** eine schematische Darstellung einer herkömmlichen Verbindungsstruktur zwischen zwei frei programmierbaren Halbleiterbausteinen;

**Fig. 2A und 2B** Zeitablaufdiagramme der Signalübertragung auf der herkömmlichen Verbindungsstruktur gemäß Fig. 1;

**Fig. 3** eine alternative, aus dem Stand der Technik bekannte Verbindungsstruktur zwischen drei frei programmierbaren Halbleiterbausteinen;

**Fig. 4** eine Verbindungsstruktur zwischen drei frei programmierbaren Halbleiterbausteinen gemäß der vorliegenden Erfindung;

**Fig. 5A und 5B** Zeitablaufdiagramme der Signalübertragung auf der erfindungsgemäßen Verbindungsstruktur gemäß Fig. 4;

**Fig. 6** ein Flußdiagramm des Verfahrens gemäß der vorliegenden Erfindung;

**Fig. 7** ein Flußdiagramm der Messung der maximalen Kommunikationsfrequenz, des Phasenverschiebungswerts und der Verzögerung für jede physikalische Verbindung;

**Fig. 8** die Berechnung der Leitungsverzögerung und der Phasenverschiebungswerte für das Clock-Signal;

**Fig. 9** Ein Flußdiagramm eines alternativen Verfahrensablaufs gemäß der vorliegenden Erfindung.

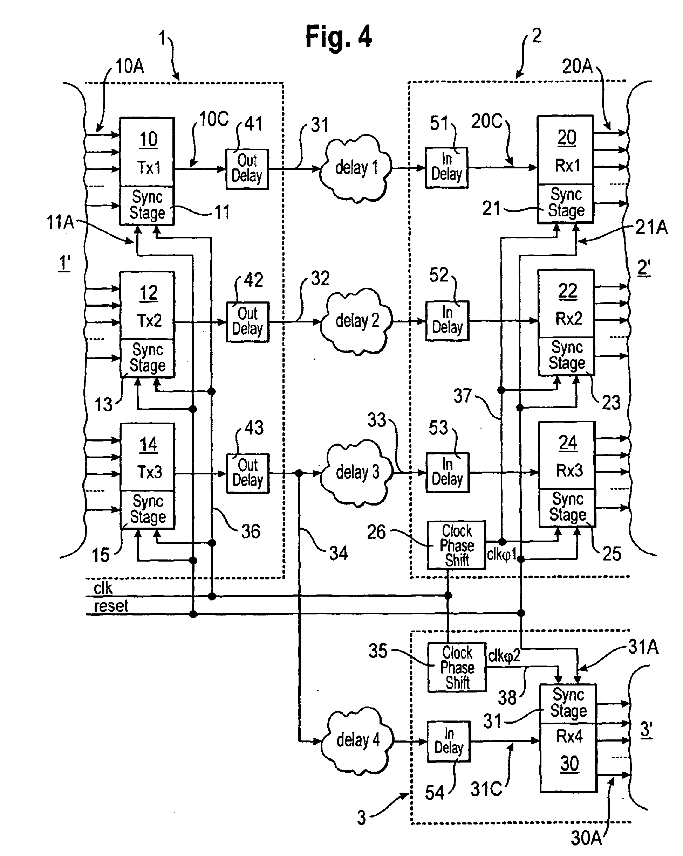

Fig. 4 zeigt den Aufbau einer Verbindungsstruktur in einer Vorrichtung zur Emulation von Hardwarebeschreibungsmodellen gemäß der vorliegenden Erfindung.

Die Figur zeigt eine Verbindungsstruktur zwischen mehreren frei programmierbaren Halbleiterbausteinen 1, 2, 3, die beispielsweise von FPGAs gebildet sind, in einer Vorrichtung zur Emulation von Hardwarebeschreibungsmodellen zur Herstellung von Prototypen für integrierte Schaltungen. In jedem der frei programmierbaren Halbleiterbausteine 1, 2, 3 ist ein Teil 1', 2', 3' eines Modells für eine zu emulierende integrierte Schaltung abgebildet. Zwischen den Teilen 1', 2', 3' des Modells werden Daten aus dem jeweils zugeordneten frei programmierbaren Halbleiterbausteinen 1, 2, 3 hinaus beziehungsweise herein und zwischen den frei programmierbaren Halbleiterbausteinen 1, 2, 3 auf physikalischen Verbindungsleitungen 31, 32, 33, 34 übertragen. Die zwischen den einzelnen Teilen 1', 2', 3' des Modells übertragenen Daten sind entsprechend des zur Datenübertragung benutzten Verbindungsschemas unterschiedlichen Verzögerungen unterworfen.

Der Datenfluß wird nachstehend beispielhaft an einer Verbindung zwischen dem ersten Teil 1' und dem zweiten Teil 2' des Modells der zu emulierenden Schaltung beschrieben. Von dem innerhalb des ersten frei programmierbaren Halbleiterbausteins 1 abgebildeten Schaltungsteil 1' werden Daten über eine Mehrzahl von Verbindungen zu Signaleingängen 10A eines im ersten frei programmierbaren Halbeiterbaustein 1 enthaltenden Serialisierers 10 geleitet.

Im Serialisierer 10 werden die eingehenden Signale zu Datenpaketen verbunden, die über einen Signalausgang 10C aus dem Serialisierer heraus zur physikalischen Verbindung 31 zu einem Deserialisierer 20 des zweiten frei programmierbaren Halbleiterbausteins 2 geführt werden, der über seinen Signaleingang 20C den übertragenden Datenstrom empfängt, ihn deserialisiert und die einzelnen Daten über seine Singalausgänge 20A an den im zweiten frei programmierbaren Halbleiterbaustein 2 abgebildeten Teil 2' der zu emulierenden Schaltung leitet.

Die Verknüpfung im Serialisierer kann beispielsweise durch zeitbasiertes Multiplexen, durch Schieberegister oder durch andere bekannte Verfahren erfolgen.

Die Verzögerung der zwischen dem ersten Schaltungsteil 1' des ersten frei programmierbaren Halbleiterbausteins 1 und dem Schaltungsteil 2' des zweiten frei programmierbaren Halbleiterbausteins 2 setzt sich im Wesentlichen zusammen aus der Verzögerung auf der physikalischen Verbindung 31 zwischen den beiden frei programmierbaren Halbleiterbausteinen 1 und 2, die im Wesentlichen durch die Länge der physikalischen Verbindung 31 und durch deren Leitungswiderstand hervorgerufen wird, sowie gegebenenfalls aus einer Ausgangsverzögerung "out delay" innerhalb des ersten frei programmierbaren Halbleiterbausteins 1 und gegebenenfalls einer Eingangsverzögerung "in delay" im zweiten frei programmierbaren Halbleiterbaustein 2.

Dazu sind der jeweiligen physikalischen Verbindung 31, 32, 33, 34 Ausgangsverzögerungsstufen 41, 42, 43 und/oder Eingangsverzögerungsstufen 51, 52, 53, 54 zugeordnet, denen bei Bedarf ein vom Verfahren berechneter Ausgangsverzögerungswert beziehungsweise Eingangsverzögerungswert zugewiesen wird. Dadurch wird erreicht, dass die Signallaufzeiten auf den jeweiligen physikalischen Verbindungen 31, 32, 33, 34 aneinander angepasst und so vergleichmäßigt werden.

Die Verbindungsstruktur gemäß der vorliegenden Erfindung ist in der Lage, die Datenübertragung zwischen dem Serialisierer 10 und dem Deserialisierer 20 mit einer Frequenz durchzuführen, die so hoch ist, dass ihre Phasenlänge kürzer ist, als die Verzögerung auf der Verbindung zwischen dem ersten Schaltungsteil 1' und dem zweiten Schaltungsteil 2'. Damit auf der Empfängerseite noch eine korrekte Auflösung des im Deserialisierer 20 ankommenden Datenstroms erfolgen kann, ist es erforderlich, dass die Taktung im Deserialisierer eine geeignete Anpassung erfährt. Diese Anpassung erfolgt nicht pauschal für alle Verbindungen zwischen zwei frei programmierbaren Halbleiterbausteinen 1, 2, sondern für die jeweilige Verbindung 31, 32, 33, 34 individuell.

Beim Beginn der Datenübertragung ist die Durchführung einer Synchronisation erforderlich, damit das vom Serialisierer 10 ausgesendete Signal im Deserialisierer 20 korrekt identifiziert werden kann. Dazu ist der Serialisierer 10 mit einer Synchronisationsstufe 11 versehen, über deren Signaleingänge 11A das Taktsignal "clk" und das Rücksetzsignal "reset" der Synchronisationsstufe 11 des Serialisierers zugeführt werden. Auch der Deserialisierer 20 enthält eine entsprechende Synchronisationsstufe 21, der über ihre Signaleingänge 21A ein vom ersten Taktsignal abweichendes verzögertes Taktsignal "clkφ1" sowie das Rücksetzsignal "reset" dem Deserialiserer 20 zugeführt werden. Die weiteren Serialisierer 12, 14 des ersten Halbleiterbausteins 1 weisen ebenfalls entsprechende Synchronisationsstufen 13, 15 auf. Auch die weiteren Deserialisierer 22, 24 des zweiten Halbleiterbausteins 2 weisen entsprechende Synchronisationsstufen 22, 25 auf.

Das Taktsignal "clkφ1" ist im gezeigten Beispiel für alle Deserialisierer 20, 22, 24 des zweiten frei programmierbaren Halbleiterbausteins 2 gemeinsam und wird in einer Takt-Phasenverschiebungsvorrichtung 26 des zweiten frei programmierbaren Halbleiterbausteins 2 aus dem senderseitigen Taktsignal "clk" erzeugt und über eine Clock-Signal-Leitung 37 den Deserialisierern 20, 22, 24 zugeführt.

Auch im dritten frei programmierbaren Halbleiterbaustein 3 wird in einer Takt-Phasenverschiebungsvorrichtung 35 ein für diesen Halbleiterbaustein 3 angepaßtes Taktsignal "clkφ2" aus dem ursprünglichen Taktsignal "clk" erzeugt und über eine Clock-Signal-Leitung 38 einer Synchronisationsstufe 31 des Daten empfangenden Deserialisierers 30 des dritten frei programmierbaren Halbleiterbausteins 3 zugeführt. Auch das Rücksetzsignal wird der Synchronisationsstufe 31 über einen von deren Eingängen 31A zugeführt. Das entsprechende, über die physikalische Verbindung 34 ankommende Datensignal wird über den Signaleingang 31C dem Deserialisierer 30 zugeführt. Die vom Deserialisierer 30 aufgelösten Daten werden dann über die Signalausgänge 30A dem im dritten frei programmierbaren Halbleiterbaustein 3 abgebildeten Schaltungsteil 3' zugeführt.

Die Datenübertragung zwischen den weiteren Serialisierern 12, 14 des ersten frei programmierbaren Halbleiterbausteins 1 und dem jeweils zugeordneten Deserialisierer 22, 24 des zweiten frei programmierbaren Halbleiterbausteins erfolgt auf dieselbe Weise wie dies oben bereits in Verbindung mit der Datenübertragung zwischen dem Serialisierer 10 und dem Deserialisierer 20 beschrieben worden ist.

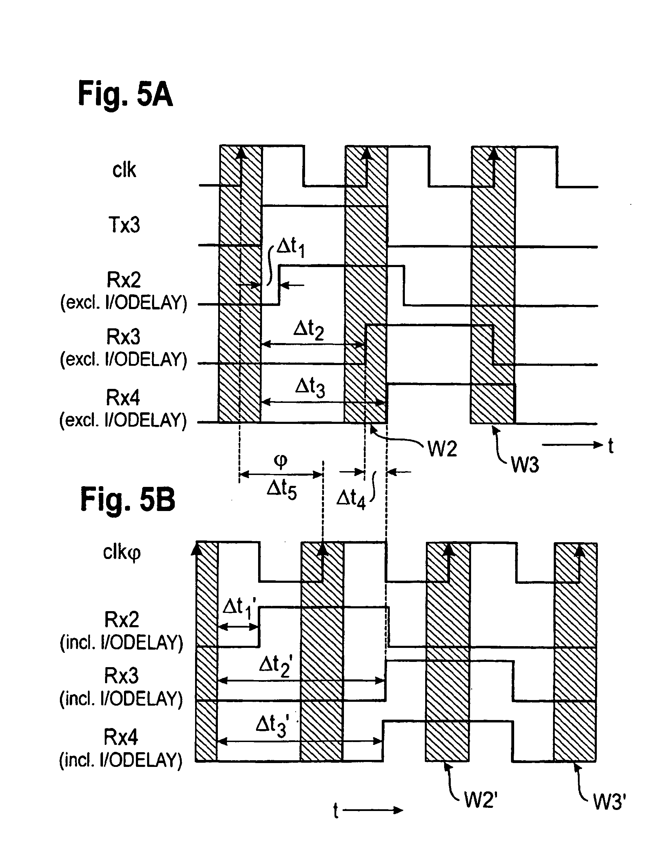

Die Figuren 5A und 5B zeigen Zeitdiagramme ähnlich den in den Figuren 2A und 2B gezeigten Diagrammen, jedoch für die in Fig. 4 dargestellte Verbindungsstruktur gemäß der vorliegenden Erfindung. Dabei zeigt Fig. 5A das dem senderseitigen ersten frei programmierbaren Halbleiterbaustein 1 zugeordnete Basis-Taktsignal "clk" sowie beispielhaft das vom dritten Serialisierer 14 ausgesendete Signal Tx3. Diese Kurve gilt analog auch für die vom ersten Serialisierer 10 und vom zweiten Serialisierer 12 ausgesendeten Signale Tx1 und Tx2. Weiterhin sind in Fig. 5A jene Signalverzögerungen $\Delta t_1$, $\Delta t_2$ und $\Delta t_3$ gezeigt, die auf der physikalischen Verbindung zu den Deserialisierern 22 (Signal Rx2), 24 (Signal Rx3) und 30 (Signal Rx4) auftreten, wobei bei diesen Verzögerungen interne Verzögerungen im jeweiligen frei programmierbaren Halbleiterbaustein 1, 2, 3, nämlich die senderseitigen Ausgangsverzögerungen "out delay" und die empfängerseitigen Eingangsverzögerungen "in delay" nicht berücksichtigt sind.

Die jeweiligen Empfangsfenster sind in den Figuren 5A und 5B durch vertikale graue Balken dargestellt.

In Fig. 5B ist das Zeitdiagramm der Signalfolge auf der jeweiligen Empfängerseite in Bezug auf das phasenverschobene Taktsignal "clkφ" dargestellt, wobei im gezeigten Beispiel das phasenverschobene Taktsignal "clkφ1" im zweiten frei programmierbaren Halbleiterbaustein 2 und das phasenverschobene Taktsignal "clkφ2" im dritten frei programmierbaren Halbleiterbaustein 3 als gleich angenommen werden und daher nur allgemein mit "clkφ" bezeichnet sind.

Des Weiteren sind in Fig. 5B über der Zeit t die jeweiligen Eingangssignale am zweiten Deserialisierer 22 (Signal Rx2), am dritten Deserialisierer 24 (Signal Rx3) des zweiten frei programmierbaren Halbleiterbausteins 2 und das Eingangssignal Rx4 am Deserialisierer 30 des dritten frei programmierbaren Halbleiterbausteins 3 gezeigt. Dabei sind die in Fig. 5B gezeigten empfangenen Signale Rx2, Rx3, Rx4 im Gegensatz zur Fig. 5A unter Berücksichtigung der jeweiligen Eingangs- und Ausgangsverzögerungen dargestellt. Beispielhaft ist in den Figuren 5A und 5B die zeitliche Verschiebung der ansteigenden Signalflanke des Signals Rx3 aufgrund der zusätzlichen Berücksichtigung der Eingangs- und Ausgangsverzögerungen als $\Delta t_4 = \Delta t_2' - \Delta t_2$ gezeigt.

Weiterhin ist in den Figuren 5A und 5B die Phasenverschiebung φ des empfängerseitigen Taktsignals "clkφ" als Zeitgröße $\Delta t_5$ angegeben, woraus deutlich wird, wie sich die Datenerfassungsfenster (zum Beispiel W3') in Fig. 5B gegenüber jenen (zum Beispiel W3') der Fig. 5A nach rechts auf der Zeitachse verschoben haben.

Betrachtet man die Darstellung in Fig. 5A, so wird deutlich, dass bei einer Messung der empfangenen Signale allein aufgrund des ursprünglichen Taktsignals "clk" die Datenerfassung des Signals Rx2 am zweiten empfängerseitigen Deserialisierer 22 des zweiten frei programmierbaren Halbleiterbausteins 2 in demselben Takt möglich ist, in dem das Signal Tx3 - und damit auch das zugehörige Signal Tx2 - ausgesendet worden ist, da beide Signale im Bereich des zweiten Messfensters W2 den Wert "high" einnehmen.

Die Erfassung des Signals Rx3 am dritten Deserialisierer 24 des zweiten frei programmierbaren Halbleiterbausteins 2 ist keinem Messfenster genau zuzuordnen, so dass das Signal möglicherweise im zweiten Messfenster W2 oder erst im dritten Messfenster W3 oder gar in beiden Messfenstern oder gar in keinem der beiden Messfenster korrekt erfaßt wird.

Das am Deserialisierer 30 des dritten frei programmierbaren Halbleiterbausteins 3 ankommende Signal Rx4 wird hingegen erst im dritten Messfenster W3 erfaßt. Diese Darstellung in Fig. 5A zeigt demnach, dass die Signalerfassung auf der jeweiligen Empfängerseite unter Verwendung des ursprünglichen Zeittaktes "clk" äußerst fehlerbehaftet ist.

Die gemäß der vorliegenden Erfindung erfolgende Phasenverschiebung φ des Taktsignals auf der Empfängerseite zur Bildung des phasenverschobenen, empfängerseitigen Taktsignals "clkφ" zeigt hingegen in Fig. 5B, dass alle empfangsseitig ankommenden Signale Rx2, Rx3 und Rx4 - auch unter Berücksichtigung der zusätzlichen Eingangs- und Ausgangsverzögerung - in einem der - phasenverschobenen - Messfenster eindeutig empfangen werden können.

Das erfindungsgemäße Vorsehen einer Phasenverschiebung für das jeweilige empfängerseitige Taktsignal, aufbauend auf dem ursprünglichen Taktsignal "clk", erlaubt es somit, trotz der Laufzeitverzögerungen auf den physikalischen Verbindungen zwischen den einzelnen frei programmierbaren Halbleiterbausteinen 1, 2, 3 und den innerhalb des jeweiligen Halbleiterbausteins auftretenden Eingangs- beziehungsweise Ausgangs-Laufzeitverzögerungen, die jeweils beim Deserialisierer eingehenden Signale eindeutig zu empfangen und auswerten zu können.

Zur Durchführung der Startsynchronisierung zu Beginn einer Datenübertragung können ein global verteiltes Rücksetzsignal "reset" und ein im jeweiligen Empfänger vorgesehener Zähler vorgesehen sein. Nach dem Aussenden des Rücksetzsignals zählt der Zähler die Zählertaktzyklen bis auf der Empfängerseite das Rücksetzsignal angekommen ist. Der Maximalwert der auf den einzelnen physikalischen Übertragungsstrecken erzielten Zählerwerte wird als die maximale Verbindungsverzögerung definiert.

Es ist ebenfalls möglich, ein Synchronisationsmuster zu Beginn der Datenübertragung auszusenden. Das Synchronisationsmuster wird auf der Senderseite erzeugt und die Empfänger sammeln alle eingehenden Signalwerte. Wenn das Synchronisationsmuster auf der Empfängerseite erkannt worden ist, können die empfangenen Signalwerte jeweils den zugeordneten gesendeten Signalwerten korrekt zugeordnet werden.

Die erfindungsgemäße Ausgestaltung der Übertragungsstruktur ermöglicht es, die Datenübertragung zwischen frei programmierbaren Halbleiterbausteinen mit größtmöglicher Geschwindigkeit nahe der physikalischen Grenze der gesamten Vorrichtung zur Emulation zu übertragen. Unterschiedliche Verzögerungen auf unterschiedlichen Verbindungswegen zwischen den einzelnen frei programmierbaren Halbleiterbausteinen werden kompensiert und die Integrität der gesendeten und empfangenen Signale wird gewährleistet. Es werden weiterhin keine zusätzlichen physikalischen Verbindungen für Synchronisationszwecke benötigt. Durch die Verwendung eines phasenverschobenen Taktsignals auf der Empfängerseite wird die Latenzzeit deutlich reduziert. Auch die Anzahl der erforderlichen Taktsignale wird gegenüber dem Stand der Technik herabgesenkt.

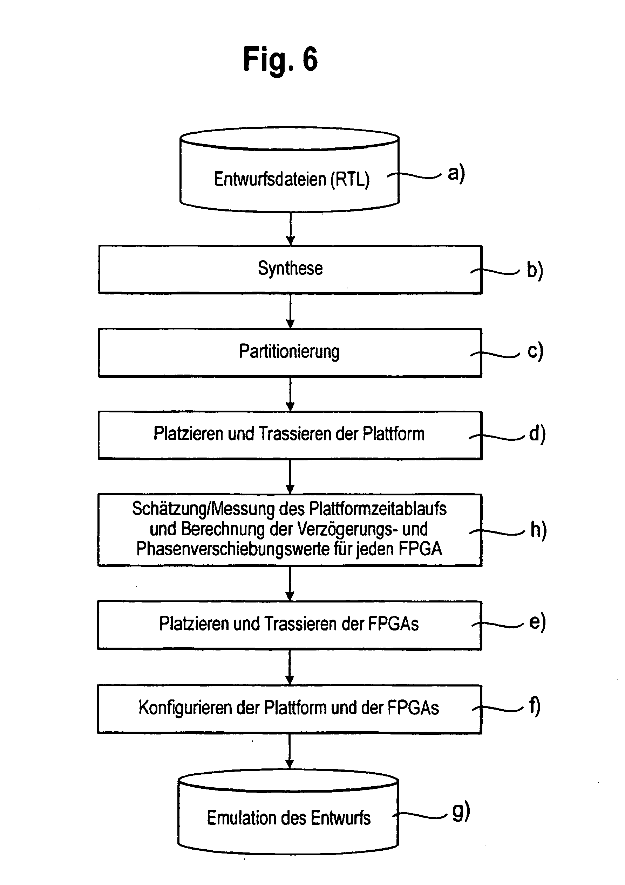

Fig. 6 zeigt ein Flußdiagramm das eine erste Ausführungsform des erfindungsgemäßen Verfahrens zur Emulation von Hardwarebeschreibungsmodellen zur Herstellung von Prototypen für integrierte Schaltungen wiedergibt.

Die zu emulierende Schaltung steht als sogenannte RTL-(Register-Transfer-Level)-Beschreibung zur Verfügung, die Hardwarebeschreibungssprachen, wie "VHDL" oder "VERILOG" verwendet. Im Schritt a) wird der Prototyp für das Chipdesign mittels der Hardwarebeschreibungssprache als Hardwarebeschreibungsmodell bereitgestellt.

Im Schritt b) wird diese RTL-Beschreibung synthetisiert und in eine Gatternetzliste übertragen.

Im Allgemeinen sind die in der Synthese enthaltenen Gatternetzlisten so komplex, dass sie sich nicht in einem einzelnen programmierbaren Halbleiterbaustein, zum Beispiel einem FPGA, zur Emulation abbilden lassen. Daher wird die Gatternetzliste im Schritt c) in eine Mehrzahl von Teilnetzlisten und in eine die Teilnetzlisten untereinander verbindende Toplevelnetzliste partitoniert. Auf diese Weise können die einzelnen Teilnetzlisten in unterschiedlichen FPGAs abgebildet werden. Jeder FPGA enthält somit Schaltungsteile 1', 2', 3' (Fig. 4) des gesamten Schaltungsdesigns. Die Toplevelnetzliste beschreibt, wie die einzelnen FPGAs oder frei programmierbaren Halbleiterbausteine, untereinander zu verbinden sind, um das gesamte Schaltungsdesign auf der Emulationsplattform abzubilden.

Im Schritt d) wird aufgrund der Toplevelnetzliste eine Verteilung der einzelnen Teilnetzlisten auf die FPGAs der Emulationsplattform vorgenommen und die erforderlichen Verbindungen zwischen den einzelnen FPGAs werden definiert und geroutet. Falls die Anzahl der erforderlichen Verbindungen zwischen den einzelnen FPGAs die Kapazität der jeweiligen Anschlüsse der FPGAs oder die Kapazität der Emulationsplattform übersteigt, wird die Anzahl der physikalisch erforderlichen Verbindungen zwischen den FPGAs reduziert, wozu beispielsweise eine Mehrzahl von Datenströmen durch die allgemein bekannte Methode der Serialisierung und der Deserialisierung über eine gemeinsame physikalische Verbindung übertragen werden.

Im Schritt h) werden dann Signal-Laufzeitverzögerungen zwischen den einzelnen Halbleiterbausteinen bestimmt und die Taktfrequenz des Clock-Signals wird optimiert. Dies erfolgt gemäß der vorliegenden Erfindung durch Berechnung aufgrund eines Zeitablaufmodells der Emulationsplattform. Alternativ kann auch eine reale Messung der Verzögerungen der einzelnen physikalischen Verbindungen durchgeführt werden. Dazu wird die Emulationsplattform mit exakt derselben Verbindungsstruktur konfiguriert, wie dies für die Implementierung des Designs erforderlich ist. Die Halbleiterbausteine, oder FPGAs, werden mit Testdesigns konfiguriert und die Testdesigns senden Testmuster auf allen physikalischen Verbindungen aus und prüfen, ob die Testmuster korrekt erhalten werden. Dabei werden die Taktfrequenz und der Phasenverschiebungswert online geändert. Im Ergebnis werden die maximale Kommunikationsfrequenz $f_n$, der Phasenverschiebungswert $\varphi_n$ und die auf Taktzyklen basierende Verzögerung $\delta_n$ für jede physikalische Verbindung bestimmt. Die auf den Taktzyklen beruhende Verzögerung $\delta_n$ ist die Verzögerung einer physikalischen Verbindung in Taktzyklen. Sie kann mit einem Zähler bestimmt werden, der nach der Synchronisierung des Verbindungssystems die Taktzyklen zählt, bis ein erstes korrektes Signal empfangen wird. Da dieser Wert die Präzision der Taktzyklen besitzt, berechnet sich der exakte Verzögerungswert aller physikalischen Verbindungen nach der Formel:

$$Verz\ddot{o}gerung = \frac{\delta_n}{f_n} + \varphi_n$$

Im Schritt e) werden dann die jeweiligen Teilnetzlisten auf jeweils einen der frei programmierbaren Halbleiterbausteine übertragen.

Im Schritt f) erfolgt dann die Konfiguration der die frei programmierbaren Halbleiterbausteine aufweisenden Emulationsplattform mit dem zu emulierenden Chipdesign.

Nach Durchführung des Schrittes f) wird im Schritt g) die Emulation des Chipdesigns durchgeführt, wobei eine Signalübertragung zwischen den frei programmierbaren Halbleiterbausteinen erfolgt, bei der von einem ersten, Signale aussendenden Halbleiterbaustein ausgehende Signale auf der Seite des ersten, Signale aussendenden Halbleiterbausteins mittels einer senderseitigen getakteten Clock-Signal serialisiert und auf der Seite eines zweiten, Signale empfangenden Halbleiterbausteins mittels eines empfängerseitigen getakteten Clock-Signals deserialisiert werden.

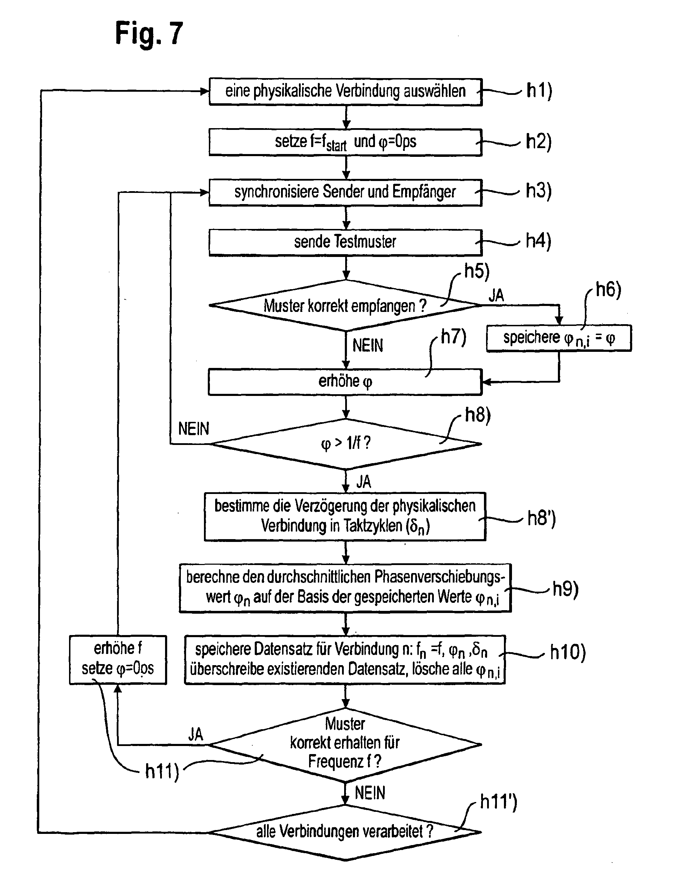

Die Fig. 7 zeigt die Bestimmung der maximalen Kommunikationsfrequenz $f_n$, des Phasenverschiebungswerts $\varphi_n$ und der auf den Taktzyklen $\delta_n$ beruhenden Verzögerung für jede physikalische Verbindung.

Im Schritt h1) wird eine erste physikalische Verbindung zwischen einem ersten Anschluß des ersten Halbleiterbausteins über einen auf der Plattform vorgesehenen Verbindungsweg zu einem ersten Anschluß des zweiten Halbleiterbausteins ausgewählt.

Es wird dann im Schritt h2) eine Start-Taktfrequenz ($f=f_{start}$) und einer Start-Phasenverschiebung von $\varphi=0°$, entsprechend einer Zeitverzögerung von 0 Picosekunden (ps), für das empfängerseitige Taktsignal oder Clock-Signal vorgegeben.

Im Schritt h3) wird dann der empfangende Halbleiterbaustein mit dem sendenden Halbleiterbaustein synchronisiert und das senderseitige getaktete Clock-Signal wird mit dem empfängerseitigen getakteten Clock-Signal gleichgesetzt.

Anschließend wird im Schritt h4) ein auf der Basis des senderseitigen getakteten Clock-Signals serialisiertes Testsignal vom ersten Halbleiterbaustein über den Verbindungsweg zum zweiten Halbleiterbaustein ausgesendet.

Im Schritt h5) wird das auf der Basis des empfängerseitigen getakteten Clock-Signals deserialisierte Testsignal am zweiten Halbleiterbaustein empfangen und es wird geprüft, ob das Testsignal korrekt empfangen worden ist.

Im Schritt h6) wird dann der Phasenverschiebungswert $\varphi$ für das empfängerseitige Clock-Signal gespeichert, wenn das Testsignal im Schritt h5) erkannt worden ist.

Unabhängig davon, ob das Testsignal im Schritt h5) erkannt worden ist, erfolgt im Schritt h7) die Erhöhung der Phasenverschiebung $\varphi$ des empfängerseitigen Taktsignals oder Clock-Signals um einen vorgegebenen Betrag. Anschließend werden die Schritte h3) bis h5) solange wiederholt, bis im Schritt h8) festgestellt wird, dass die Phasenverschiebung $\varphi$ des empfängerseitigen Taktsignals größer ist, als der Kehrwert der 1/f der Taktfrequenz f des senderseitigen Taktsignals oder Clock-Signals.

Im folgenden Schritt h8') wird die Signalverzögerung $\delta_n$ auf der gewählten physikalischen Verbindung in Taktzyklen des senderseitigen Taktsignals ermittelt.

Anschließend wird im Schritt h9) der durchschnittliche Phasenverschiebungswert $\varphi_n$ aus den im Schritt h6) gespeicherten Phasenverschiebungswerten berechnet, wobei das arithmetische Mittel der Phasenverschiebungswerte $\varphi_{ni}$ bestimmt wird.

Im folgenden Schritt h10) werden die Daten für die aktuelle Taktfrequenz $f_n$, für den durchschnittlichen Phasenverschiebungswert $\varphi_n$, sowie für die im Schritt h8') ermittelte Signalverzögerung $\delta_n$ als ein aktueller Datensatz gespeichert. Der vorher existierende Datensatz wird überschrieben und alle bisherigen durchschnittlichen Phasenverschiebungswerte werden gelöscht.

Ist das Testsignal im Schritt h5) korrekt empfangen worden, so wird im Schritt h11) die Taktfrequenz f um einen vorgegebenen Betrag erhöht und die Phasenverschiebung $\varphi$ wird auf den Anfangswert $\varphi=0°$ zurückgesetzt. Dann werden die Schritte h3) bis h10) wiederholt. Ist jedoch im Schritt h5) das Testsignal nicht mehr erkannt worden, so wird vom Schritt h10) zum Schritt h11') übergegangen, in welchem überprüft wird, ob alle physikalischen Verbindungen verarbeitet worden sind. Ist dies der Fall, so ist die Prozedur beendet; ist dies jedoch nicht der Fall, so werden die Schritte h1) bis h11) für die weiteren physikalischen Verbindungen zwischen dem ersten Halbleiterbaustein und dem zweiten Halbleiterbaustein wiederholt.

Auf diese Weise werden die maximale Kommunikationsfrequenz $f_n$, der Phasenverschiebungswert $\varphi_n$ und die auf den Taktzyklen beruhende Verzögerung $\delta_n$ für jede physikalische Verbindung ermittelt.

Auf der Basis dieser exakten Verzögerungswerte einer jeden physikalischen Verbindung, die zum Beispiel in Picosekunden (ps) gemessen werden, werden die Phasenverschiebungswerte für das Taktsignal einer jeden physikalischen Verbindung ermittelt und den Eingangs- und Ausgangsstufen der FPGA-Netzlisten zugewiesen.

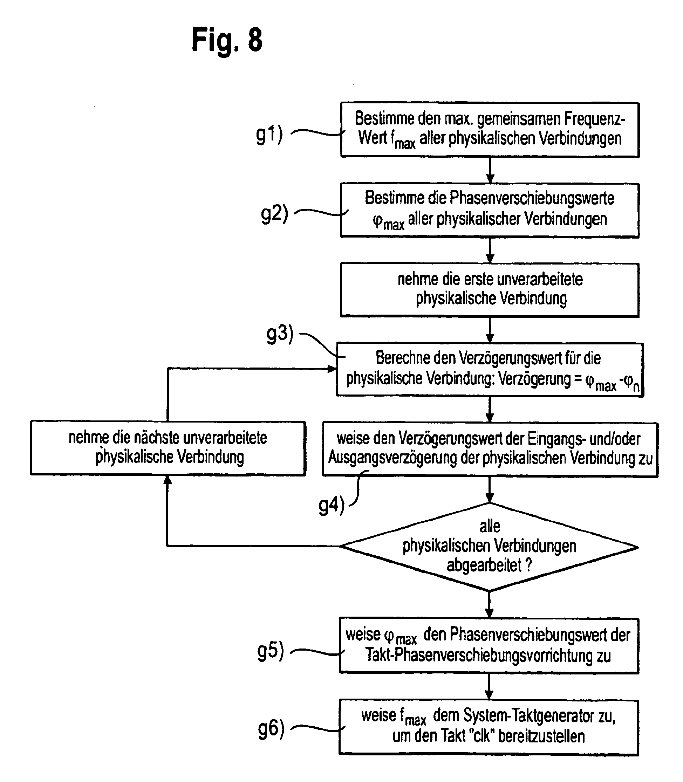

Fig. 8 zeigt die Berechnung der Verzögerung auf den einzelnen physikalischen Verbindungen und der Werte für die Phasenverschiebung der Taktsignale.

Zunächst wird im Schritt g1) die allen physikalischen Verbindungen gemeinsame, in den Schritten h1) bis h11') ermittelte höchste Taktfrequenz $f_{max}$ ermittelt. Dieser Wert stellt die maximale gemeinsame Kommunikationsfrequenz aller physikalischen Verbindungen dar.

Anschließend wird im Schritt g2) der größte Phasenverschiebungsbetrag $\varphi_{max}$ der in den Schritten h1) bis h11') ermittelten Phasenverschiebungsbeträge aller physikalischen Verbindungen ermittelt. Es wird dann der erste noch nicht verarbeitete physikalische Verbindungsweg ausgewählt und im Schritt g3) wird der Verzögerungswert für diese physikalische Verbindung als Differenz zwischen dem größten Phasenverschiebungsbetrag $\varphi_{max}$ und dem in den Schritten h1) bis h11') ermittelten Phasenverschiebungsbetrag $\varphi_n$ der physikalischen Verbindung $V_n$ berechnet. Dies erfolgt nach der Formel:

$$[3]$$

$$\text{Verzögerung} = \Delta\varphi_n = \varphi_{max} - \varphi_n$$

Anschließend wird im Schritt g4) der jeweilige Verzögerungswert $\Delta\varphi_n$ zu einer Eingangs- und/oder Ausgangs-Verzögerungsstufe der zugeordneten physikalischen Verbindung $V_n$ zugewiesen.

Es wird dann überprüft, ob alle physikalischen Verbindungen abgearbeitet worden sind, falls dies nicht der Fall ist, wird zur nächsten unverarbeiteten physikalischen Verbindung übergegangen und die Schritte g3) und g4) werden wiederholt.

Sind alle physikalischen Verbindungen abgearbeitet, so wird zum Schritt g5) übergegangen. Der größte Phasenverschiebungsbetrag $\varphi_{max}$ wird im Schritt g5) einer Phasenverschiebungsstufe für das Taktsignal oder Clock-Signal zugewiesen.

Schließlich wird im Schritt g6) die im Schritt g1) ermittelte höchste Taktfrequenz $f_{max}$ dem Erzeuger des ursprünglichen Taktsignals "clk" zugewiesen und das Taktsignal oder Clock-Signal wird mit der diesem Erzeuger zuge-

wiesenen höchsten Taktfrequenz $f_{max}$ erzeugt und in die erfindungsgemäße Vorrichtung eingespeist.

Auf diese Weise kann die Emulation mit der für diesen Anwendungsfall höchsten geeigneten Taktfrequenz $f_{max}$ durchgeführt werden, wobei das Taktsignal auf der entsprechenden Empfängerseite mit dem berechneten Wert $\varphi_{max}$ zum empfängerseitigen Taktsignal "clkφ" gewandelt wird.

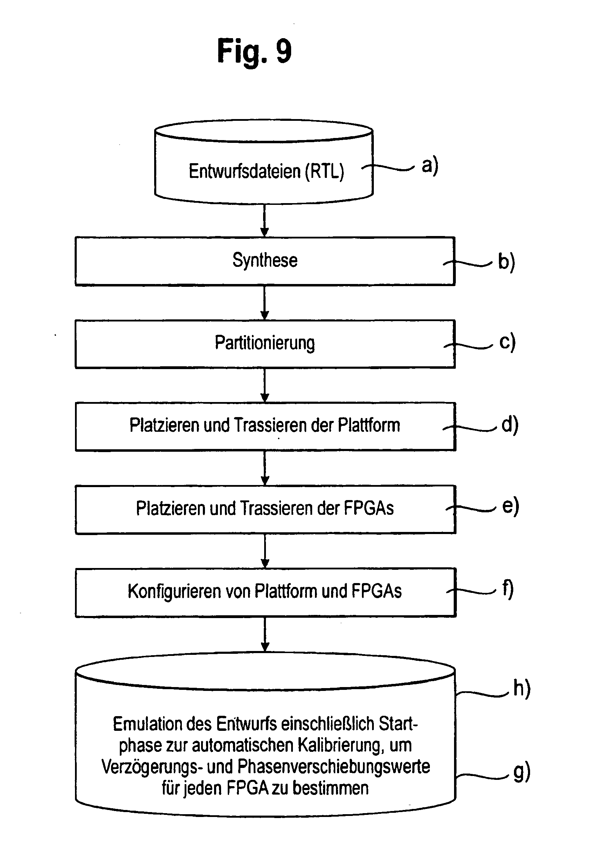

In Fig. 9 ist eine alternative Ausführungsform des erfindungsgemäßen Verfahrens dargestellt, wie es grundsätzlich in Fig. 6 gezeigt ist. Dabei wird nach dem in Fig. 9 gezeigten abgewandelten Verfahren der Schritt h) nicht zwischen den Schritten d) und e) durchgeführt, sondern zu Beginn des Schrittes g) in einer Startphase der Emulation des Designs, also zwischen den Schritten f) und g). Dabei ist der Schritt h) als automatische Kalibrierungsphase zu Beginn der Designemulation ausgestaltet. Dazu führt die Emulationsplattform vor dem eigentlichen Beginn der Emulation des Schaltungsdesigns eine Messung der Verzögerungen für jede physikalische Verbindung durch und berechnet den Phasenverschiebungswert und die Verzögerungswerte automatisch. Diese Integration des Schrittes h) in die Startphase der Emulation des Schrittes g) erlaubt es, den im Ausführungsbeispiel der Fig. 6 vorgesehenen Schritt h) zwischen den Schritten d) und e) wegzulassen.

Die Verbindungsstruktur gemäß der vorliegenden Erfindung kann nicht nur zur Verbindung zwischen den frei programmierbaren Halbleiterbausteinen (FPGAs) einer Emulationsplattform oder einer sogenannten "rapid prototyping platform" verwendet werden, um die Funktionalität des Schaltungsdesigns zu realisieren, sondern dieses Verbindungsschema kann auch verwendet werden, um die Fehlersuchfähigkeiten ("debugging capabilities") einer solchen Plattform zu verbessern. Dazu wird das Verbindungsschema für eine Signalübertragung von den frei programmierbaren Halbleiterbausteinen, die Teile des Schaltungsdesigns emulieren, zu einem frei programmierbaren Halbleiterbaustein, beispielsweise einem FPGA, ausgestaltet, der die Funktionalität eines Logikanalysators (logic analyzer) besitzt. Der Vorteil dieser Ausführungsform liegt darin, dass durch die Bündelung der einzelnen Datenübertragungswege auf wenige physikalische Verbindungen und der erfindungsgemäßen Kompensation von Laufzeitverzögerungen gegenüber den bisherigen Logikanalysatoren wesentlich mehr Signalwerte überwacht werden können.

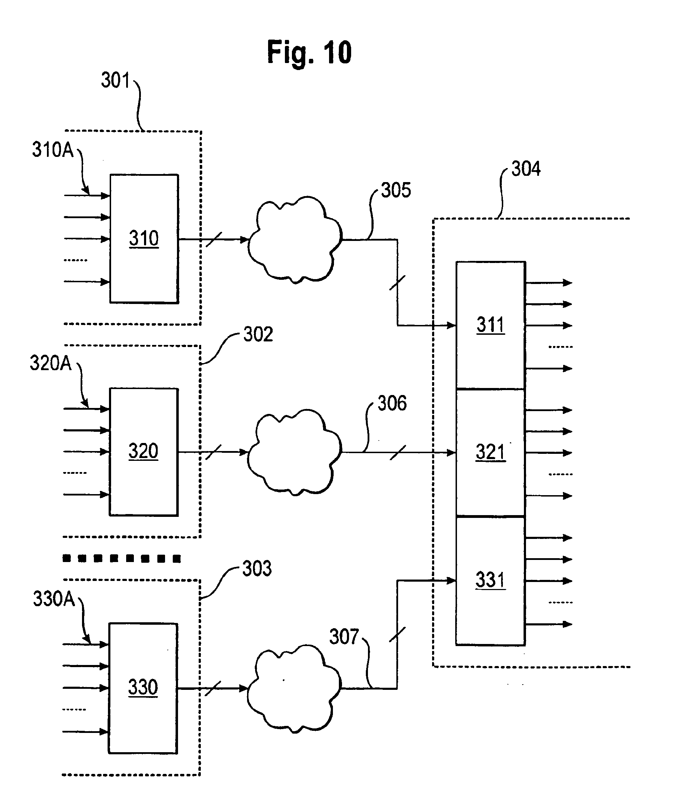

In Fig. 10 ist ein derartiger Aufbau schematisch dargestellt, wobei ein erster FPGA 301, ein zweiter FPGA 302 und ein dritter FPGA 303 jeweils mit einem Serialisierer 310, 320, 330 versehen ist, von denen jeweils eine Vielzahl von eingehenden Signalen 310A, 320A, 330A über jeweils eine physikalische Verbindung 305, 306, 307 zu einem Logikanalysator 304 geleitet werden und dort in jeweils einem zugeordneten Deserialisierer 311, 321, 331 deserialisiert werden. Dabei werden, auch wenn dies in der Fig. 10 nicht im Detail dargestellt ist, dieselben Verfahrensschritte angewendet und es sind dieselben Vorrichtungen vorgesehen, wie dies vorstehend beispielsweise in Verbindung mit der Fig. 4 und den zugehörigen Verfahrensabläufen der Figuren 6 bis 9 beschrieben worden ist.

Die Erfindung ist nicht auf das obige Ausführungsbeispiel beschränkt, das lediglich der allgemeinen Erläuterung des Kerngedankens der Erfindung dient. Im Rahmen des Schutzumfangs können die erfindungsgemäße Vorrichtung und das erfindungsgemäße Verfahren vielmehr auch andere als die oben beschriebenen Ausgestaltungsformen annehmen. Die Vorrichtung kann hierbei insbesondere Merkmale aufweisen, die eine Kombination aus den jeweiligen Einzelmerkmalen der Ansprüche darstellen.

Bezugszeichen in den Ansprüchen, der Beschreibung und den Zeichnungen dienen lediglich dem besseren Verständnis der Erfindung und sollen den Schutzumfang nicht einschränken.

**Patentansprüche**

1. Verfahren zur Emulation von Hardwarebeschreibungsmodellen zur Herstellung von Prototypen für integrierte Schaltungen mit den Schritten:

    a) Bereitstellen eines Prototyps für ein Chipdesign, das mittels einer Hardwarebeschreibungssprache als Hardwarebeschreibungsmodell erstellt worden ist;
    b) Übertragen des Hardwarebeschreibungsmodells in eine Gatternetzliste;
    c) Partitionieren der Gatternetzliste in eine Mehrzahl von Teilnetzlisten und in eine die Teilnetzlisten untereinander verbindende Toplevelnetzliste;
    d) Übertragen der in Teilnetzlisten partitionierten Gatternetzliste auf eine zumindest zwei frei programmierbare Halbleiterbausteine aufweisende Emulationsplattform;
    e) Übertragen einer jeden Teilnetzliste auf jeweils einen der frei programmierbaren Halbleiterbausteine;
    f) Konfigurieren der die frei programmierbaren Halbleiterbausteine aufweisenden Emulationsplattform mit dem zu emulierenden Chipdesigns;
    g) Durchführen der Emulation des Chipdesigns, wobei eine Signalübertragung zwischen den frei programmierbaren Halbleiterbausteinen erfolgt, bei der von einem ersten, Signale aussendenden Halbleiterbaustein ausgehende Signale auf der Seite des ersten, Signale aussendenden Halbleiterbausteins mittels eines senderseitigen getakteten Clock-Signals serialisiert und auf der Seite eines zweiten, Signale empfangenden Halbleiterbausteins mittels eines empfängerseitigen getakteten Clock-Signals deserialisiert werden;

- wobei im Verfahrensablauf bis zur Durchführung der Emulation des Chipdesigns im Schritt g) zusätzlich der folgende Schritt ausgeführt wird:

h) Bestimmen von Signal-Laufzeitverzögerungen zwischen den einzelnen Halbleiterbausteinen und Optimierung der Taktfrequenz des Clock-Signals
und

- wobei die ermittelten Signal-Laufzeitverzögerungen bei der Emulation im Schritt g) berücksichtigt werden;

**dadurch gekennzeichnet,**
**dass** zur Bestimmung der Signal-Laufzeitverzögerungen und zur Optimierung der Taktfrequenz des Clock-Signals im Schritt h) zwischen dem ersten, Signale aussendenden Halbleiterbaustein und dem zweiten, Signale empfangenden Halbleiterbaustein die folgenden Schritte durchgeführt werden:

h1) Auswählen einer ersten physikalischen Verbindung zwischen einem ersten Anschluss des ersten Halbleiterbausteins über einen auf der Plattform vorgesehenen Verbindungsweg zu einem ersten Anschluss des zweiten Halbleiterbausteins;
h2) Vorgeben einer Start-Taktfrequenz ($f=f_{Start}$) und einer Start-Phasenverschiebung von $\varphi=0°$ für das empfängerseitige Clock-Signal;
h3) Synchronisieren des empfangenden Halbleiterbausteins mit dem sendenden Halbleiterbaustein und Gleichsetzen des senderseitigen getakteten Clock-Signals mit dem empfängerseitigen getakteten Clock-Signal;
h4) Aussenden eines auf der Basis des senderseitigen getakteten Clock-Signals serialisierten Testsignals vom ersten Halbleiterbaustein über den Verbindungsweg zum zweiten Halbleiterbaustein;
h5) Empfangen des auf der Basis des empfängerseitigen getakteten Clock-Signals deserialisierten Testsignals am zweiten Halbleiterbaustein und Prüfen, ob das Testsignal korrekt empfangen wird;
h6) Speichern des Phasenverschiebungswerts ($\varphi$) für das empfängerseitige Clock-Signal, wenn das Testsignal im Schritt h5) erkannt worden ist;
h7) Erhöhen der Phasenverschiebung ($\varphi$) des empfängerseitigen Clock-Signals um einen vorgegebenen Betrag;
h8) Wiederholen der Schritte h3) bis h5) so lange bis die Phasenverschiebung ($\varphi$) des empfängerseitigen Clock-Signals größer ist, als der Kehrwert der Taktfrequenz (f) des senderseitigen Clock-Signals;
h9) Berechnen des durchschnittlichen Phasenverschiebungswerts ($\varphi_n$) aus den im Schritt h6) gespeicherten Phasenverschiebungswerten;
h10) Speichern der Daten für

- die aktuelle Taktfrequenz ($f_n$)
- den durchschnittlichen Phasenverschiebungswert ($\varphi_n$)
als aktueller Datensatz; und

h11) Erhöhen der Taktfrequenz (f) um einen vorgegebenen Betrag und Rücksetzen der Phasenverschiebung ($\varphi$) auf den Anfangswert $\varphi=0°$, wenn das Testsignal im Schritt h5) noch erkannt worden ist und Wiederholen der Schritte h3) bis h10); oder
h11') Wiederholen der Schritte h1) bis h11) für die weiteren physikalischen Verbindungen zwischen dem ersten Halbleiterbaustein und dem zweiten Halbleiterbaustein, wenn das Testsignal im Schritt h5) nicht mehr erkannt worden ist.

2. Verfahren nach Anspruch 1,
**dadurch gekennzeichnet,**
**dass** Schritt h) zwischen den Schritten d) und e) oder zwischen den Schritten f) und g) durchgeführt wird.

3. Verfahren nach Anspruch 1,
**dadurch gekennzeichnet**,
zwischen den Schritten h8) und h9) noch der folgende Schritt durchgeführt wird:

h8') Ermitteln der Signalverzögerung ($\delta_n$) auf der gewählten physikalischen Verbindung in Taktzyklen des senderseitigen Clock-Signals;
und dass die so ermittelte Signalverzögerung ($b_n$) im Schritt h10) im aktuellen Datensatz ebenfalls gespeichert wird.

4. Verfahren nach Anspruch 1 oder 3,
**dadurch gekennzeichnet,**
**dass** die Schritte h1) bis h11') bei Vorhandensein von mehr als zwei frei programmierbaren Halbleiterbausteinen auf der Plattform für alle physikalischen Verbindungen zwischen den einzelnen Halbleiterbausteinen durchgeführt werden.

5. Verfahren nach Anspruch 1, 3 oder 4,
**dadurch gekennzeichnet,**
**dass** zur Berücksichtigung der Signal-Laufzeitverzögerungen bei der Emulation im Schritt

    g) die folgenden Schritte durchgeführt werden:

        g1) Ermitteln der allen physikalischen Verbindungen gemeinsamen, in den Schritten h1) bis h11') ermittelten höchsten Taktfrequenz ($f_{max}$);
        g2) Ermitteln des größten Phasenverschiebungsbetrags ($\varphi_{max}$) der in den Schritten h1) bis h11') ermittelten Phasenverschiebungsbeträge aller physikalischen Verbindungen;
        g3) Berechnen eines jeweiligen Verzögerungswerts ($\Delta\varphi_n$) für jede der auf der Plattform vorgesehenen physikalischen Verbindungen als Differenz zwischen dem größten Phasenverschiebungsbetrag ($\varphi_{max}$) und dem in den Schritten h1) bis h11') ermittelten Phasenverschiebungsbetrag ($\varphi_n$) der jeweiligen physikalischen Verbindung ($V_n$);
        g4) Zuweisen des jeweiligen Verzögerungswerts ($\Delta\varphi_n$) zu einer Eingangs- und/oder Ausgangs-Verzögerungsstufe der zugeordneten physikalischen Verbindung ($V_n$);
        g5) Zuweisen des größten Phasenverschiebungsbetrags ($\varphi_{max}$) zu einer Phasenverschiebungsstufe für das Clock-Signal;
        g6) Zuweisen der im Schritt g1) ermittelten höchsten Taktfrequenz ($f_{max}$) zum Clock-Signal-Erzeuger und Erzeugen des Clock-Signals mit der zugewiesenen höchsten Taktfrequenz ($f_{max}$).

6. Verfahren nach einem der Ansprüche 1 bis 4,
**dadurch gekennzeichnet,**
**dass** der Schritt des Synchronisierens des empfangenden Halbleiterbausteins mit dem sendenden Halbleiterbaustein im Schritt h2)

    - durch Verwendung eines globalen Rücksetzsignals und eines Synchronisationszählers auf der Seite des empfangenden Halbleiterbausteins erfolgt
    oder
    - durch Verwendung eines Synchronisations-Signalmusters erfolgt, das vom sendenden Halbleiterbaustein ausgesandt und vom empfangenden Halbleiterbaustein verarbeitet wird.

7. Verfahren nach einem der Ansprüche 1 bis 6,
**dadurch gekennzeichnet,**
**dass** die Serialisierung durch zeitbasiertes Multiplexen oder durch Verwendung eines zeitbasierten Schieberegisters erfolgt.

8. Verfahren nach einem der Ansprüche 1 bis 7,
**dadurch gekennzeichnet,**
**dass** die Phasenlänge des Clock-Signals kleiner ist, als die Signalverzögerung der physikalischen Verbindung.

9. Verfahren zur Prognose einer maximalen Arbeitsfrequenz eines Chipdesigns mit den Schritten:

    x) Durchführen einer Timing-Analyse eines gemäß dem Verfahren nach einem der vorhergehenden Ansprüche emulierten Chipdesigns, um eine optimierte Basis-Arbeitsfrequenz zu erhalten, und
    y) Korrigieren der im Schritt x) erhaltenen Basis-Arbeitsfrequenz um die bei der optimierten Taktfrequenz im Schritt h) erhaltenen Laufzeitverzögerungen.

**10.** Vorrichtung zur Durchführung eines Verfahrens gemäß einem der vorhergehenden Ansprüche mit

- einer Emulationsplattform, die einen ersten frei programmierbaren Halbleiterbaustein (1) und zumindest einen weiteren frei programmierbaren Halbleiterbaustein (2; 3) aufweist, wobei die frei programmierbaren Halbleiterbausteine jeweils mit einer Vielzahl von elektrischen Anschlüssen versehen sind;
- einer Vielzahl von physikalischen Verbindungen (31, 32, 33, 34), die Anschlüsse des ersten frei programmierbaren Halbleiterbausteins (1) mit jeweils einem zugeordneten Anschluss des weiteren frei programmierbaren Halbleiterbausteins (2; 3) elektrisch verbinden;
- wobei jedem frei programmierbaren Halbleiterbaustein zumindest eine Ausgangs-Verzögerungsstufe (41, 42, 43) zum Verzögern von auszusendenden Signalen und/oder zumindest eine Eingangs-Verzögerungsstufe (51, 52, 53, 54) zum Verzögern von zu empfangenden Signalen derart zugeordnet ist, dass die Signale aussendenden Anschlüsse des frei programmierbaren Halbleiterbausteins (1) mit der Ausgangs-Verzögerungsstufe (41, 42, 43) wirksam verbunden sind und die Signale empfangenden Anschlüsse des frei programmierbaren Halbleiterbausteins (2; 3) mit der Eingangs-Verzögerungsstufe (51, 52, 53, 54) wirksam verbunden sind;
**dadurch gekennzeichnet,**
- **dass** einer jeweiligen Ausgangs-verzögerungsstufe (41, 42, 43) eines jeden frei programmierbaren Halbleiterbausteins (1) eine erste Synchronisationsstufe (11, 13, 15) zugeordnet ist;
- **dass** einer jeweiligen Eingangs-Verzögerungsstufe (51, 52, 53, 54) eines jeden frei programmierbaren Halbleiterbausteins (2; 3) eine zweite Synchronisationsstufe (21, 23, 25, 31) zugeordnet ist;
- **dass** die ersten Synchronisationsstufen der frei programmierbaren Halbleiterbausteine der Emulationsplattform über eine erste Clock-Signal-Leitung (36) mit einem ersten Taktsignal beaufschlagt sind;
- **dass** die zweiten Synchronisationsstufen der frei programmierbaren Halbleiterbausteine über zumindest eine weitere Clock-Signal-Leitung (37; 38) mit einem phasenverschobenen weiteren Taktsignal beaufschlagt sind; und
- **dass** die erste Clock-Signal-Leitung (36) für das erste Taktsignal über eine Vorrichtung zur Phasenverschiebung (36;35) mit der weiteren Clock-Signal-Leitung (37; 38) für das phasenverschobene weitere Taktsignal elektrisch verbunden ist.

**11.** Vorrichtung nach Anspruch 10,
**dadurch gekennzeichnet,**

- **dass** einer jeweiligen Ausgangs-Verzögerungsstufe (41, 42, 43) ein Serialisierer (10, 12, 14) zugeordnet ist und
- **dass** einer jeweiligen Eingangs-Verzögerungsstufe (51, 52, 53, 54) ein Deserialisierer (20, 22, 24, 30) zugeordnet ist.

**12.** Vorrichtung nach Anspruch 10,
**dadurch gekennzeichnet,**
**dass** mehrere Gruppen von weiteren frei programmierbaren Halbleiterbausteinen (2, 3) vorgesehen sind, wobei die frei programmierbaren Halbleiterbausteine (2, 3) einer jeden Gruppe mit einer eigenen, dieser Gruppe zugeordneten Clock-Signal-Leitung (37, 38) für ein phasenverschobenes Taktsignal elektrisch verbunden sind, die über eine dieser Gruppe zugeordnete Vorrichtung zur Phasenverschiebung (26, 35) mit der ersten Clock-Signal-Leitung (36) elektrisch verbunden ist.

**13.** Vorrichtung nach einem der Ansprüche 10 bis 12,
**dadurch gekennzeichnet,**
**dass** die Eingangs-Verzögerungsstufen (51, 52, 53, 54), die Ausgangs-Verzögerungsstufen (41, 42, 43), die Serialisierer (10, 12, 14), die Deserialisierer (20, 22, 24, 30), die Synchronisationsstufen (11, 21) und/oder die Vorrichtungen zur Phasenverschiebung (26, 35) im jeweils zugeordneten frei programmierbaren Halbleiterbaustein (1, 2, 3) gebildet sind.

**14.** Vorrichtung nach einem der Ansprüche 10 bis 13,
**dadurch gekennzeichnet,**
**dass** die frei programmierbaren Halbleiterbausteine (1, 2, 3) durch FPGAs gebildet sind, und/oder dass der erste frei programmierbare Halbleiterbaustein (301) von einem eine Schaltungslogik aufweisenden FPGA gebildet ist und dass der zweite frei programmierbare Halbleiterbaustein (304) einen Logic-Analyzer aufweist.

**Claims**

1. A method for emulating hardware description models for producing prototypes for integrated circuits, comprising the following steps:

   a) providing a prototype for a chip design, which has been generated as a hardware description model by means of a hardware description language;
   b) transferring the hardware description model into a grid list;
   c) partitioning the grid list into a plurality of partial grid lists and into a top level grid list, connecting said partial grid lists amongst one another;
   d) transferring the grid list, which is partitioned into partial grid lists, into an emulation platform comprising at least two freely programmable semiconductor components;
   e) transferring each partial grid list into one of the respective freely programmable semiconductor components;
   f) configuring the emulation platform with the chip design to be emulated, wherein said emulation platform comprises the freely programmable semiconductor components;
   g) performing the emulation of the chip design, wherein a signal transmission between the freely programmable semiconductor components is performed, in which signals originating at a first signal transmitting semiconductor component are serialized by a transmitter side timed clock signal on the side of the first signal transmitting semiconductor component, and deserialized by a receiver side timed clock signal on the side of a second signal receiving semiconductor component,

   - wherein the subsequent step is additionally performed in the method sequence up to performing the emulation of the chip design in step g):

   h) determining signal-runtime delays between the particular semiconductor components and optimizing the timing frequency of the clock signal
   and

   - wherein the determined signal-runtime delays are considered in the emulation in step g);

   **characterized**
   **in that** in order to determine the signal-runtime delays and to optimize the timing frequency of the clock signal in step h) between the first signal transmitting semiconductor component and the second signal receiving semiconductor component, the following steps are performed:

   h1) selecting a first physical connection between a first connection of the first semiconductor component through a connection path provided on the platform to a first connection of the second semiconductor component;
   h2) specifying a start-timing frequency ($f=f_{start}$) and a start-phase shift of $\varphi=0°$ for the receiver side clock signal;
   h3) synchronizing the receiving semiconductor component with the transmitting semiconductor component and equating the transmitter side timed clock signal with the receiver side timed clock signal;
   h4) transmitting a test signal which is serialized on the basis of the transmitter side timed clock signal from the first semiconductor component through the connection path to the second semiconductor component;
   h5) receiving the test signal which is deserialized based on the receiver side timed clock signal at the second semiconductor component and verifying that the test signal is received correctly;
   h6) saving the phase-shift value ($\varphi$) for the receiver side clock signal, when the test signal has been detected in step h5);
   h7) increasing the phase-shift value ($\varphi$) of the receiver side clock signal by a specified amount;
   h8) repeating the steps h3) through h5) until the phase-shift value ($\varphi$) of the receiver side clock signal is greater than the inverse of the timing frequency ($f$) of the transmitter side clock signal;
   h9) computing the average phase-shift value ($\varphi_n$) from the phase-shift values stored in step h6);
   h10) storing the data for

   - the actual timing frequency ($f_n$)
   - the average phase-shift value ($\varphi_n$)
   as an actual data set; and

h11) increasing the timing frequency (f) by a specified amount and resetting the phase-shift value ($\varphi$) to the start value $\varphi=0°$, when the test signal has still been detected in step h5) and repeating steps h3) through h10); or

h11') repeating steps h1) through h11) for the other physical connections between the first semiconductor component and the second semiconductor component when the test signal has not been recognized anymore in step h5).

2. A method according to claim 1,
**characterized**
**in that** step h) is performed between steps d) and e) or between steps f) and g).

3. A method according to claim 1,
**characterized**
**in that** between the steps h8) and h9), the following step is additionally performed:

h8') determining the signal delay ($\delta_n$) in the selected physical connection in timing cycles of the transmitter side clock signal;

and **in that** the signal delay ($\delta_n$) thus determined is also stored in the current data set in step h10).

4. A method according to claim 1 or 3,
**characterized**
**in that** the steps h1) through h11') are performed for all physical connections between the particular semiconductor components, when more than two freely programmable semiconductor components exist on the platform.

5. A method according to claim 1, 3, or 4,
**characterized**
**in that** in order to consider the signal-runtime delays during the emulation, the following steps are performed in step g):

g1) determining the highest timing frequency ($f_{max}$) determined in steps h1) through h11'), which is common to all physical connections;
g2) determining the greatest absolute phase-shift value ($\varphi_{max}$) of the absolute phase-shift values of all physical connections determined in steps h1) through h11');
g3) computing a respective delay value ($\Delta\varphi_n$) for each of the physical connections provided on the platform as a difference between the greatest absolute phase-shift value ($\varphi_{max}$) and the absolute phase-shift value ($\varphi_n$) of the respective physical connection ($V_n$) determined in steps h1) through h11');
g4) assigning the respective delay value ($\Delta\varphi_n$) to an input- and/or output delay stage of the assigned physical connection ($V_n$);
g5) assigning the greatest absolute phase-shift value ($\varphi_{max}$) to a phase-shift stage for the clock signal;
g6) assigning the highest timing frequency ($f_{max}$) determined in step g1) to the clock signal generator, and generating the clock signal with the assigned highest timing frequency ($f_{max}$).

6. A method according to one of the claims 1 through 4,
**characterized**
**in that** the step of synchronizing the receiving semiconductor component with the transmitting semiconductor component is performed in step h2)

- by using a global reset signal and a synchronization counter on the side of the receiving semiconductor component
or
- by using a synchronization-signal pattern, which is transmitted by the transmitting semiconductor component and which is processed by the receiving semiconductor component.

7. A method according to one of the claims 1 through 6,
**characterized**
**in that** the serialization is performed by time based multiplexing or by using a time based shift register.

8. A method according to one of the claims 1 through 7,

**characterized**
**in that** the phase length of the clock signal is less than the signal delay of the physical connection.

9. A method for predicting a maximum operating frequency of a chip design, comprising the following steps:

   x) performing a timing analysis of a chip design emulated according to the method according to one of the preceding claims in order to obtain an optimized basic operating frequency; and
   y) correcting the basic operating frequency obtained in step x) with the runtime delays obtained at the optimized timing frequency in step h).

10. A device for performing a method according to one of the preceding claims comprising

   - an emulation platform, which comprises a first freely programmable semiconductor component (1) and at least one other freely programmable semiconductor component (2; 3), wherein the freely programmable semiconductor components are respectively provided with a plurality of electrical connections;
   - a plurality of physical connections (31, 32, 33, 34), which electrically connect connections of the first freely programmable semiconductor component (1) with a respectively assigned connection of the other freely programmable semiconductor component (2; 3);
   - wherein at least one output delay stage (41, 42, 43) for delaying signals to be transmitted and/or at least one input delay stage (51, 52, 53, 54) for delaying signals to be received, is associated with each freely programmable semiconductor component, so that the signal transmitting connections of the freely programmable semiconductor component (1) are operatively connected to the output delay stage (41, 42, 43) and the signal receiving connections of the freely programmable semiconductor component (2; 3) are operatively connected to the input delay stage (51, 52, 53, 54)
   **characterized in that**
   - a first synchronization stage (11, 13, 15) is associated with a respective output delay stage (41, 42, 43) of each freely programmable semiconductor component (1);
   - a second synchronization stage (21, 23, 25, 31) is associated with a respective input delay stage (51, 52, 53, 54) of each freely programmable semiconductor component (2; 3);
   - the first synchronization stages of the freely programmable semiconductor components of the emulation platform are provided with a first timing signal through a first clock signal conductor (36);
   - the second synchronization stages of the freely programmable semiconductor components are provided with a phase-shifted additional clock signal through at least one additional clock signal conductor (37; 38); and
   - the first clock signal conductor (36) for the first clock signal is electrically connected through a phase-shifting device (36; 35) to another clock signal conductor (37; 38) for the phase-shifted additional clock signal.

11. A device according to claim 10,
    **characterized**

   - **in that** a serializer (10, 12, 14) is associated with a respective output delay stage (41, 42, 43); and
   - **in that** a deserializer (20, 22, 24, 30) is associated with a respective input delay stage (51, 52, 53, 54).

12. A device according to claim 10,
    **characterized**
    **in that** plural groups of additional freely programmable semiconductor components (2, 3) are provided, wherein the freely programmable semiconductor components (2, 3) of each group are electrically connected with a dedicated clock signal conductor (37, 38) for a phase-shifted timing signal, associated with said group, and said clock signal conductor is electrically connected with the first clock signal conductor (36) associated with said group, through a phase-shifting device (26, 35).

13. A method according to one of the claims 10 through 12,
    **characterized**
    **in that** the input delay stages (51, 52, 53, 54), the output delay stages (41, 42, 43), the serializers (10, 12, 14), the deserializers (20, 22, 24, 30), the synchronization stages (11, 21), and/or the phase-shifting devices (26, 35) are formed in the respectively associated freely programmable semiconductor component (1, 2, 3).

14. A device according to one of the claims 10 through 13,
    **characterized**

**in that** the freely programmable semiconductor components (1, 2, 3) are formed by FPGAs and/or
**in that** the first freely programmable semiconductor component (301) is formed by an FPGA, which comprises circuit logic, and in that the second freely programmable semiconductor component (304) comprises a logic analyzer.

## Revendications

1. Procédé d'émulation de modèles de description de matériel pour la fabrication de prototypes pour circuits intégrés, comprenant les étapes consistant à :

   a) fournir un prototype pour une conception de puce qui a été réalisé sous la forme d'un modèle de description de matériel au moyen d'un langage de description de matériel ;
   b) transférer le modèle de description de matériel dans une liste d'interconnexions de portes logiques ;
   c) partitionner la liste d'interconnexions de portes logiques en une pluralité de listes d'interconnexions partielles et en une liste d'interconnexions de niveau supérieur reliant entre elles les listes d'interconnexions partielles ;
   d) transférer la liste d'interconnexions de portes logiques partitionnée en listes d'interconnexions partielles sur une plateforme d'émulation présentant au moins deux composants à semi-conducteurs librement programmables ;
   e) transférer chaque liste d'interconnexions partielle sur chaque fois un des composants à semi-conducteurs librement programmables ;
   f) configurer la plateforme d'émulation présentant les composants à semi-conducteurs librement programmables avec la conception de puce à émuler ;
   g) exécuter l'émulation de la conception de puce, une transmission de signal entre les composants à semi-conducteurs librement programmables ayant lieu, lors de laquelle des signaux provenant d'un premier composant à semi-conducteurs émetteur de signaux sont sérialisés au moyen d'un signal d'horloge cadencé côté émetteur du côté du premier composant à semi-conducteurs émetteur de signaux, et désérialisés au moyen d'un signal d'horloge cadencé côté récepteur du côté d'un deuxième composant à semi-conducteurs récepteur de signaux,

      - l'étape suivante étant en plus effectuée dans la séquence de procédé allant jusqu'à l'exécution de l'émulation de la conception de puce à l'étape g) :

   h) détermination des retards de propagation de signal entre les composants à semi-conducteurs individuels et optimisation de la fréquence de cadencement du signal d'horloge
   et

      - les retards de propagation de signal déterminés étant pris en compte lors de l'émulation à l'étape g) ;

   **caractérisé en ce**
   **que** pour déterminer les retards de propagation de signal et optimiser la fréquence de cadencement du signal d'horloge à l'étape h) entre le premier composant à semi-conducteurs émetteur de signaux et le deuxième composant à semi-conducteurs récepteur de signaux sont exécutées les étapes suivantes consistant à :

      h1) sélectionner une première liaison physique entre une première connexion du premier composant à semi-conducteurs et une première connexion du deuxième composant à semi-conducteurs via une voie de liaison prévue sur la plateforme ;
      h2) définir une fréquence de cadencement de départ ($f = f_{Start}$) et un déphasage de départ de $\varphi = 0°$ pour le signal d'horloge côté récepteur ;
      h3) synchroniser le composant à semi-conducteurs récepteur avec le composant à semi-conducteurs émetteur et égaliser le signal d'horloge cadencé côté émetteur avec le signal d'horloge cadencé côté récepteur ;
      h4) émettre un signal de test sérialisé sur la base du signal d'horloge cadencé côté émetteur par le premier composant à semi-conducteurs vers le deuxième composant à semi-conducteurs via la voie de liaison ;
      h5) recevoir le signal de test désérialisé sur la base du signal d'horloge cadencé côté récepteur au deuxième composant à semi-conducteurs et vérifier si le signal de test est correctement reçu ;
      h6) enregistrer la valeur du déphasage ($\varphi$) pour le signal d'horloge côté récepteur si le signal de test a été détecté à l'étape h5) ;
      h7) augmenter le déphasage ($\varphi$) du signal d'horloge côté récepteur d'un montant prédéfini ;
      h8) répéter les étapes h3) à h5) jusqu'à ce que le déphasage ($\varphi$) du signal d'horloge côté récepteur soit plus grand que la valeur inverse de la fréquence de cadencement (f) du signal d'horloge côté émetteur ;

h9) calculer la valeur moyenne de déphasage ($\varphi_n$) à partir des valeurs de déphasage enregistrées à l'étape h6) ;

h10) enregistrer les données pour

  - la fréquence de cadencement actuelle ($f_n$)
  - la valeur moyenne de déphasage ($\varphi_n$)

en tant qu'enregistrement actuel ; et

h11) augmenter la fréquence de cadencement (f) d'un montant prédéfini et réinitialiser le déphasage ($\varphi$) à la valeur initiale $\varphi = 0°$ si le signal de test a encore été détecté à l'étape h5) et répéter les étapes h3) à h10) ; ou h11') répéter les étapes h1) à h11) pour les autres liaisons physiques entre le premier composant à semi-conducteurs et le deuxième composant à semi-conducteurs si le signal de test n'a plus été détecté à l'étape h5).

**2.** Procédé selon la revendication 1,
**caractérisé en ce**
**que** l'étape h) est exécutée entre les étapes d) et e) ou entre les étapes f) et g).

**3.** Procédé selon la revendication 1,
**caractérisé en ce**
**qu'**entre les étapes h8) et h9) est encore exécutée l'étape suivante consistant à :

h8') déterminer le retard de signal ($\delta_n$) sur la liaison physique choisie en cycles de cadencement du signal d'horloge côté émetteur ;
et **que** le retard de signal ($\delta_n$) ainsi déterminé est également enregistré dans l'enregistrement actuel à l'étape h10).

**4.** Procédé selon la revendication 1 ou 3,
**caractérisé en ce**
**qu'**en cas de présence de plus de deux composants à semi-conducteurs librement programmables sur la plateforme, les étapes h1) à h11') sont exécutées pour toutes les liaisons physiques entre les différents composants à semi-conducteurs.

**5.** Procédé selon la revendication 1, 3 ou 4,
**caractérisé en ce**
**que** pour tenir compte des retards de propagation de signal lors de l'émulation à l'étape g) sont exécutées les étapes suivantes consistant à :

g1) déterminer la fréquence de cadencement ($f_{max}$) la plus élevée commune à toutes les liaisons physiques déterminée aux étapes h1) à h11') ;
g2) déterminer le plus grand montant de déphasage ($\varphi_{max}$) des montants de déphasage déterminés aux étapes h1) à h11') de toutes les liaisons physiques ;
g3) calculer une valeur de retard respective ($\Delta\varphi_n$) pour chacune des liaisons physiques prévues sur la plateforme en tant que différence entre le plus grand montant de déphasage ($\varphi_{max}$) et le montant de déphasage ($\varphi_n$) déterminé aux étapes h1) à h11') de la liaison physique respective ($V_n$) ;
g4) affecter la valeur de retard respective ($\Delta\varphi_n$) à un étage de retard d'entrée et/ou de sortie de la liaison physique associée ($V_n$) ;
g5) affecter le plus grand montant de déphasage ($\varphi_{max}$) à un étage de déphasage pour le signal d'horloge ;
g6) affecter la fréquence de cadencement ($f_{max}$) la plus élevée déterminée à l'étape g1) au générateur de signal d'horloge et générer le signal d'horloge avec la fréquence de cadencement ($f_{max}$) la plus élevée affectée.

**6.** Procédé selon l'une des revendications 1 à 4,
**caractérisé en ce**
**que** l'étape consistant à synchroniser le composant à semi-conducteurs récepteur avec le composant à semi-conducteurs émetteur à l'étape h2)

  - est effectuée en utilisant un signal de réinitialisation global et un compteur de synchronisation du côté du composant à semi-conducteurs récepteur

ou

- est effectuée en utilisant un modèle de signal de synchronisation qui est émis par le composant à semi-conducteurs émetteur et traité par le composant à semi-conducteurs récepteur.

7. Procédé selon l'une des revendications 1 à 6,
**caractérisé en ce**
**que** la sérialisation est effectuée par multiplexage temporel ou en utilisant un registre à décalage temporel.

8. Procédé selon l'une des revendications 1 à 7,
**caractérisé en ce**
**que** la longueur de phase du signal d'horloge est plus petite que le retard de signal de la liaison physique.

9. Procédé pour prédire une fréquence de travail maximale d'une conception de puce, comprenant les étapes consistant à :

x) effectuer une analyse temporelle d'une conception de puce émulée selon le procédé selon l'une des revendications précédentes pour obtenir une fréquence de travail de base optimisée, et

y) corriger la fréquence de travail de base obtenue à l'étape x) des retards de propagation obtenus à la fréquence de cadencement optimisée à l'étape h).

10. Dispositif pour mettre en oeuvre un procédé selon l'une des revendications précédentes, comprenant

- une plateforme d'émulation qui présente un premier composant à semi-conducteurs librement programmable (1) et au moins un autre composant à semi-conducteurs (2 ; 3) librement programmable, les composants à semi-conducteurs librement programmables étant chaque fois munis d'une pluralité de connexions électriques ;
- une pluralité de liaisons physiques (31, 32, 33, 34) qui relient électriquement des connexions du premier composant à semi-conducteurs librement programmable (1) à chaque fois à une connexion associée de l'autre composant à semi-conducteurs librement programmable (2 ; 3) ;
- au moins un étage de retard de sortie (41, 42, 43) pour retarder des signaux à émettre et/ou au moins un étage de retard d'entrée (51, 52, 53, 54) pour retarder des signaux à recevoir étant associé à chaque composant à semi-conducteurs librement programmable de façon que les connexions émettant des signaux du composant à semi-conducteurs librement programmable (1) soit reliées fonctionnellement à l'étage de retard de sortie (41, 42, 43) et les connexions recevant des signaux du composant à semi-conducteurs librement programmable (2 ; 3) soit reliées fonctionnellement à l'étage de retard d'entrée (51, 52, 53, 54) ;
**caractérisé en ce**
- **qu'**un premier étage de synchronisation (11, 13, 15) est associé à un étage de retard de sortie respectif (41, 42, 43) de chaque composant à semi-conducteurs librement programmable (1) ;
- **qu'**un deuxième étage de synchronisation (21, 23, 25, 31) est associé à un étage de retard d'entrée respectif (51, 52, 53, 54) de chaque composant à semi-conducteurs librement programmable (2 ; 3) ;
- **que** les premiers étages de synchronisation des composants à semi-conducteurs librement programmables de la plateforme d'émulation sont soumis à un premier signal de cadencement via une première ligne de signal d'horloge (36) ;
- **que** les deuxièmes étages de synchronisation des composants à semi-conducteurs librement programmables sont soumis à un autre signal de cadencement déphasé via au moins une autre ligne de signal d'horloge (37 ; 38) ; et
- **que** la première ligne de signal d'horloge (36) pour le premier signal de cadencement est reliée électriquement à l'autre ligne de signal d'horloge (37 ; 38) pour l'autre signal de cadencement déphasé via un dispositif de déphasage (36 ; 35).

11. Dispositif selon la revendication 10,
**caractérisé en ce**

- **qu'**un sérialiseur (10, 12, 14) est associé à un étage de retard de sortie respectif (41, 42, 43) et
- **qu'**un désérialiseur (20, 22, 24, 30) est associé à un étage de retard d'entrée respectif (51, 52, 53, 54).

12. Dispositif selon la revendication 10,
**caractérisé en ce**

**que** plusieurs groupes d'autres composants à semi-conducteurs librement programmables (2, 3) sont prévus, les composants à semi-conducteurs librement programmables (2, 3) de chaque groupe étant reliés électriquement à une ligne de signal d'horloge (37, 38) propre, associée à ce groupe, pour un signal de cadencement déphasé, qui est reliée électriquement, via un dispositif de déphasage (26, 35) associé à ce groupe, à la première ligne de signal d'horloge (36).

13. Dispositif selon l'une des revendications 10 à 12,
**caractérisé en ce**
**que** les étages de retard d'entrée (51, 52, 53, 54), les étages de retard de sortie (41, 42, 43), les sérialiseurs (10, 12, 14), les désérialiseurs (20, 22, 24, 30), les étages de synchronisation (11, 21) et/ou les dispositifs de déphasage (26, 35) sont formés dans le composant à semi-conducteurs librement programmable (1, 2, 3) respectivement associé.

14. Dispositif selon l'une des revendications 10 à 13,
**caractérisé en ce**
**que** les composants à semi-conducteurs librement programmables (1, 2, 3) sont formés par des FPGA, et/ou
**que** le premier composant à semi-conducteurs librement programmable (301) est formé par un FPGA présentant une logique d'interconnexion et que le deuxième composant à semi-conducteurs librement programmable (304) présente un analyseur logique.

# Fig. 1
(Stand der Technik)

# Fig. 2A
(Stand der Technik)

clk

Tx3

$\Delta t_1$

Rx3

$\Delta t_2$

Rx4

W2

t ——————→

# Fig. 2B
(Stand der Technik)

clk

Tx3

$\Delta t_1{}'$

Rx3

$\Delta t_2{}'$

Rx4

W2    W3

t ——————→

# Fig. 3

## (Stand der Technik)

# Fig. 4

# Fig. 5A

# Fig. 5B

# Fig. 6

Entwurfsdateien (RTL) — a)

↓

Synthese — b)

↓

Partitionierung — c)

↓

Platzieren und Trassieren der Plattform — d)

↓

Schätzung/Messung des Plattformzeitablaufs und Berechnung der Verzögerungs- und Phasenverschiebungswerte für jeden FPGA — h)

↓

Platzieren und Trassieren der FPGAs — e)

↓

Konfigurieren der Plattform und der FPGAs — f)

↓

Emulation des Entwurfs — g)

# Fig. 7

eine physikalische Verbindung auswählen — h1)

setze $f=f_{start}$ und $\varphi=0ps$ — h2)

synchronisiere Sender und Empfänger — h3)

sende Testmuster — h4)

Muster korrekt empfangen ? — h5)

JA → speichere $\varphi_{n,i} = \varphi$ — h6)

NEIN

erhöhe $\varphi$ — h7)

$\varphi > 1/f$ ? — h8)

NEIN

JA

bestimme die Verzögerung der physikalischen Verbindung in Taktzyklen ($\delta_n$) — h8')

berechne den durchschnittlichen Phasenverschiebungswert $\varphi_n$ auf der Basis der gespeicherten Werte $\varphi_{n,i}$ — h9)

erhöhe f setze $\varphi=0ps$

speichere Datensatz für Verbindung n: $f_n =f$, $\varphi_n$ ,$\delta_n$ überschreibe existierenden Datensatz, lösche alle $\varphi_{n,i}$ — h10)

Muster korrekt erhalten für Frequenz f ?

JA — h11)

NEIN

alle Verbindungen verarbeitet ? — h11')

# Fig. 8

g1) → Bestimme den max. gemeinsamen Frequenz-Wert $f_{max}$ aller physikalischen Verbindungen

g2) → Bestimme die Phasenverschiebungswerte $\varphi_{max}$ aller physikalischer Verbindungen

nehme die erste unverarbeitete physikalische Verbindung

g3) → Berechne den Verzögerungswert für die physikalische Verbindung: Verzögerung = $\varphi_{max} - \varphi_n$

nehme die nächste unverarbeitete physikalische Verbindung

weise den Verzögerungswert der Eingangs- und/oder Ausgangsverzögerung der physikalischen Verbindung zu

g4)

alle physikalischen Verbindungen abgearbeitet ?

g5) → weise $\varphi_{max}$ den Phasenverschiebungswert der Takt-Phasenverschiebungsvorrichtung zu

g6) → weise $f_{max}$ dem System-Taktgenerator zu, um den Takt "clk" bereitzustellen

# Fig. 9

Entwurfsdateien (RTL) — a)

↓

Synthese — b)

↓

Partitionierung — c)

↓

Platzieren und Trassieren der Plattform — d)

↓

Platzieren und Trassieren der FPGAs — e)

↓

Konfigurieren von Plattform und FPGAs — f)

↓

— h)

Emulation des Entwurfs einschließlich Startphase zur automatischen Kalibrierung, um
Verzögerungs- und Phasenverschiebungswerte
für jeden FPGA zu bestimmen

— g)

# Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7007254 B1
- US 7086025 A
- US 5850537 A